# EUROPEAN PATENT APPLICATION

(11) **EP 4 429 433 A1**
(43) Date of publication of application: **11.09.2024**
(21) Application number: 24158444.0
(22) Date of filing: 19.02.2024
(51) Int. Cl.: H10B 12/00

(54) **SEMICONDUCTOR DEVICES**

(30) Priority: 08.03.2023 KR 20230030408
(71) Applicant: Samsung Electronics Co., Ltd., Suwon-si, Gyeonggi-do 16677 (KR)
(72) Inventor: KIM, Keunnam, 16677 Suwon-si (KR); KO, Seungbo, 16677 Suwon-si (KR); KIM, Jongmin, 16677 Suwon-si (KR); KIM, Huijung, 16677 Suwon-si (KR); PARK, Sangjae, 16677 Suwon-si (KR); PARK, Taejin, 16677 Suwon-si (KR); YOON, Chansic, 16677 Suwon-si (KR); LEE, Kiseok, 16677 Suwon-si (KR); LEE, Myeongdong, 16677 Suwon-si (KR)
(74) Representative: Marks & Clerk LLP

(57) **Abstract**

A semiconductor device includes an active pattern array including active patterns, an isolation pattern, gate structures, bit line structures, and lower and upper contact plugs. The isolation pattern covers sidewalls of the active patterns. The gate structures extend through upper portions of the active patterns and the isolation pattern in a first direction, and are spaced apart from each other in a second direction. The bit line structures are on central portions of the active patterns and the isolation pattern, extend in the second direction, and are spaced apart from each other in the first direction. The lower contact plugs are disposed on end portions of the active patterns. The upper contact plugs are disposed on the lower contact plugs. The active pattern array includes active pattern rows including the active patterns spaced apart from each other in the first direction.

## Description

### BACKGROUND

### 1. Field

Example embodiments of the present disclosure relate to a semiconductor device. More particularly, example embodiments of the present disclosure relate to a DRAM device.

### 2. Description of the Related Art

A dynamic random access memory (DRAM) device may include active patterns, lower contact plugs respectively formed on end portions of the active patterns, and upper contact plugs respectively formed on the lower contact plugs.

Distances between the lower contact plugs included in the DRAM device are not uniform, and thus forming the upper contact plugs on the lower contact plugs, respectively, is difficult.

### SUMMARY

According to example embodiments, there is provided a semiconductor device. The semiconductor device may include an active pattern array, an isolation pattern, gate structures, bit line structures, lower contact plugs and upper contact plugs. The active pattern array may include active patterns on a substrate. The isolation pattern may be formed on the substrate, and may cover sidewalls of the active patterns. Each of the gate structures may extend through upper portions of the active patterns and the isolation pattern in a first direction substantially parallel to an upper surface of the substrate, and the gate structures may be spaced apart from each other in a second direction substantially parallel to the upper surface of the substrate and substantially perpendicular to the first direction. The bit line structures may be formed on central portions of the active patterns and the isolation pattern, each of the bit line structures may extend in the second direction, and the bit line structures may be spaced apart from each other in the first direction. The lower contact plugs may be respectively disposed on end portions of the active patterns. The upper contact plugs may be respectively disposed on the lower contact plugs. The active pattern array may include active pattern rows spaced apart from each other in the second direction, and each of the active pattern rows may include ones of the active patterns spaced apart from each other in the first direction.

According to example embodiments, there is provided a semiconductor device. The semiconductor device may include active patterns, gate structures, bit line structures, lower contact plugs and upper contact plugs. The active patterns may be formed on a substrate. Each of the gate structures may extend through upper portions of the active patterns in a first direction substantially parallel to an upper surface of the substrate. The bit line structures may be formed on central portions of the active pattern, and each of the bit line structures may extend in a second direction substantially parallel to the upper surface of the substrate and substantially perpendicular to the first direction. The lower contact plugs may be respectively disposed on end portions of the active patterns. The upper contact plugs may be respectively disposed on the lower contact plugs. A distance in the second direction between upper surfaces of the lower contact plugs disposed in the second direction may be substantially constant, and a sidewall in the second direction of each of the lower contact plugs may have a shape of a staircase.

According to example embodiments, there is provided a semiconductor device. The semiconductor device may include active patterns, gate structures, bit line structures, lower contact plugs and upper contact plugs. The active patterns may be formed on a substrate. Each of the gate structures may extend through upper portions of the active patterns in a first direction substantially parallel to an upper surface of the substrate. The bit line structures may be formed on central portions of the active pattern, and each of the bit line structures may extend in a second direction substantially parallel to the upper surface of the substrate and substantially perpendicular to the first direction. The lower contact plugs may be respectively disposed on end portions of the active patterns, and each of the lower contact plugs may include a first conductive pattern and a second conductive pattern sequentially stacked in a vertical direction substantially perpendicular to the upper surface of the substrate. The upper contact plugs may be respectively disposed on the lower contact plugs. A distance in the second direction between the first conductive patterns may not be constant, and a distance in the second direction between the second conductive patterns may be substantially constant.

According to an embodiment there is provided a semiconductor device comprising: a substrate; active patterns on the substrate; gate structures extending in a first direction through upper portions of the active patterns, the first direction being substantially parallel to an upper surface of the substrate; bit line structures on central portions of the active pattern, the bit line structures extending in a second direction substantially parallel to the upper surface of the substrate and substantially perpendicular to the first direction; lower contact plugs respectively on end portions of the active patterns, a distance in the second direction between upper surfaces of the lower contact plugs in the second direction being substantially constant, and wherein a distance between lower surfaces of adjacent ones of the lower contact plugs in the second direction is not constant; and upper contact plugs respectively on the lower contact plugs. One or more sidewalls of the lower contact plugs may have sloped and/or stepped shapes.

According to a further embodiment the semiconductor device comprises an isolation pattern on the substrate, the isolation pattern covering sidewalls of the active patterns, wherein the gate structures extend in the first direction through the isolation pattern. The gate structures may be spaced apart from each other in the second direction. The bit line structures may be on the isolation pattern and may be spaced apart from each other in the first direction. According to an embodiment, the active patterns are arranged in active pattern rows spaced apart from each other in the second direction, and each of the active pattern rows includes some of the active patterns spaced apart from each other in the first direction and aligned with each other in the first direction, wherein each of the active patterns extends in a third direction at an acute angle with respect to each of the first direction and the second direction.

At least some of the above and other features of the invention are set out in the claims.

### BRIEF DESCRIPTION OF THE DRAWINGS

Features will become apparent to those of skill in the art by describing in detail embodiments with reference to the attached drawings, in which:
FIGS. 1 to 3 are a plan view and cross-sectional views of a semiconductor device in accordance with example embodiments.
FIGS. 4 to 29 are plan views and cross-sectional views of stages in a method of manufacturing a semiconductor device in accordance with example embodiments.
FIG. 30 is a cross-sectional view illustrating a semiconductor device in accordance with example embodiments.
FIGS. 31 and 32 are cross-sectional views taken along lines A-A' of corresponding plan views, respectively, illustrating a method of manufacturing a semiconductor device in accordance with example embodiments.
FIG. 33 is a cross-sectional view illustrating a semiconductor device in accordance with example embodiments.
FIGS. 34 to 36 are cross-sectional views taken along lines A-A' of corresponding plan views, respectively, illustrating a method of manufacturing a semiconductor device in accordance with example embodiments.

### DETAILED DESCRIPTION

Hereinafter, two directions among horizontal directions that are substantially parallel to an upper surface of a substrate 100 (e.g. a substrate 100 of a semiconductor device), which may be substantially orthogonal to each other, may be referred to as first and second directions D1 and D2, respectively. Directions among the horizontal directions, which may have an acute angle with respect to each of the first and second directions D1 and D2, may be referred to as third and fourth directions D3 and D4, respectively. A vertical direction may be a direction substantially perpendicular to the upper surface of the substrate 100 (e.g. substantially perpendicular to the first to fourth directions D1-D4). The vertical direction may define a height direction of the semiconductor device. "Upper" portions of a particular component may be higher, or further along the vertical direction (e.g. further from the upper surface of the substrate 100), than "lower" portions of the same component. It will be appreciated that the directions defined herein are defined relative to the structure of the semiconductor device, and need not imply any particular orientation of the semiconductor device in use.

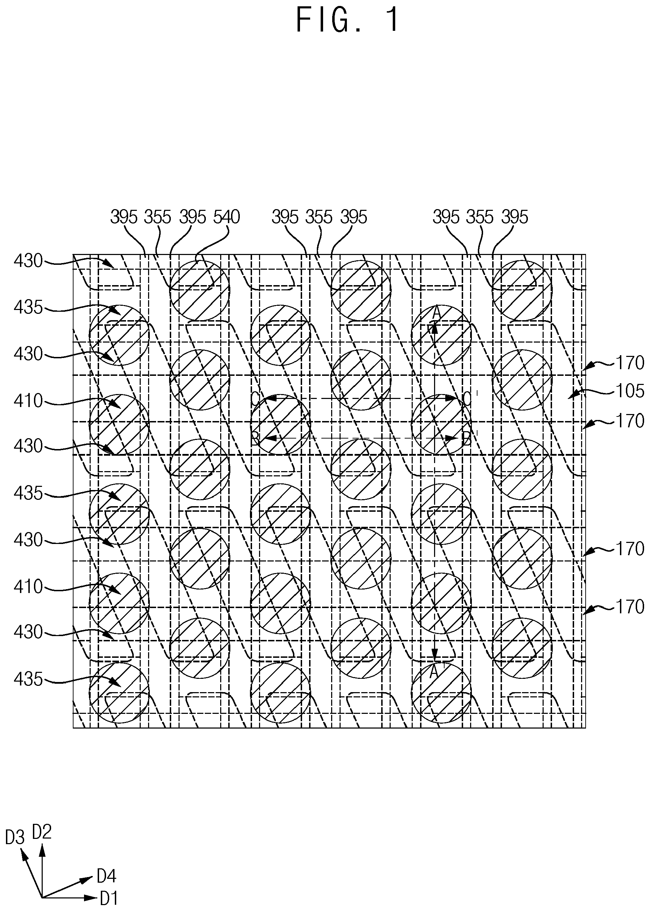

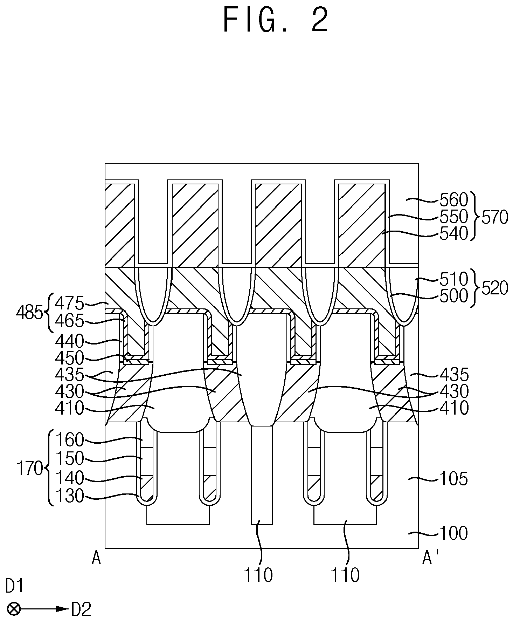

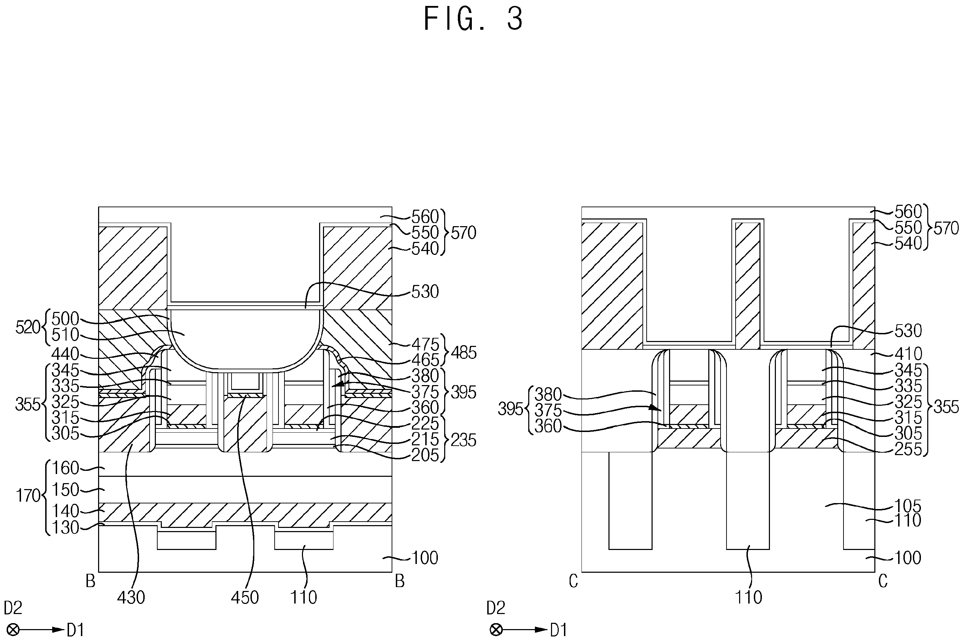

FIGS. 1 to 3 are a plan view and cross-sectional views illustrating a semiconductor device in accordance with example embodiments. Specifically, FIG. 1 is a plan view of a semiconductor device in accordance with example embodiments, FIG. 2 illustrates a cross-sectional view along line A-A' of FIG. 1, and FIG. 3 illustrates cross-sectional views along lines B-B' and C-C' of FIG. 1.

Referring to FIGS. 1-3, a semiconductor device may include an active pattern 105, a gate structure 170, a bit line structure 355, a conductive filling pattern 255, a contact plug structure having a lower contact plug 430, a second ohmic contact pattern 450 and an upper contact plug 485, and a capacitor 570 on the substrate 100. The semiconductor device may further include an isolation pattern 110, a spacer structure 395, a fourth spacer 440, a first ohmic contact pattern, first and second fence patterns 410 and 435, first and third insulation pattern structures 235 and 520, and a second etch stop layer 530.

For example, the substrate 100 may include silicon, germanium, silicon-germanium, or a III-V group compound semiconductor, e.g., GaP, GaAs, GaSb, etc. In example embodiments, the substrate 100 may be a silicon-on-insulator (SOI) substrate or a germanium-on-insulator (GOI) substrate.

The active pattern 105 may be defined (e.g. located) on the substrate 100. A sidewall of the active pattern 105 may be covered by the isolation pattern 110 on the substrate 100.

In example embodiments, the active pattern 105 may extend in the third direction D3 to a certain length, and a plurality of active patterns 105 may be spaced apart from each other in the first and third direction D1 and D3 to form an active pattern array. In example embodiments, the active pattern array may include an active pattern row including active patterns 105 disposed in the first direction D1, and a plurality of active pattern rows may be spaced apart from each other in the second direction D2. The active patterns 105 included in each of the active pattern rows may be aligned with each other in the first direction D 1. That is, end portions in the third direction D3 of ones of the active patterns 105 included in each of the active pattern rows, which may correspond to each other, may be aligned with each other along the first direction D1 (e.g. located at the same position along the second direction D2).

The active pattern 105 may include a material substantially the same as a material of the substrate 100. For example, the isolation pattern 110 may include an oxide, e.g., silicon oxide. An impurity region including, e.g., n-type impurities or p-type impurities, may be formed at an upper portion of the active pattern 105.

The gate structure 170 may extend in the first direction D1 through upper portions of the active pattern 105 and the isolation pattern 110. The gate structure 170 may include a first conductive pattern 140, a second conductive pattern 150, and a gate mask 160 sequentially stacked in a vertical direction substantially perpendicular to the upper surface of the substrate 100, and sidewalls of the first conductive pattern 140, the second conductive pattern 150, and the gate mask 160 and a lower surface of the first conductive pattern 140 may be covered by a gate insulation pattern 130. The first and second conductive patterns 140 and 150 may collectively form (e.g., define) a gate electrode.

For example, the gate insulation pattern 130 may include an oxide, e.g., silicon oxide, the first conductive pattern 140 may include, e.g., a metal, a metal nitride, or a metal silicide, the second conductive pattern 150 may include, e.g., polysilicon doped with n-type impurities or p-type impurities, and the gate mask 160 may include an insulating nitride, e.g., silicon nitride.

In example embodiments, the gate structure 170 may extend (e.g., lengthwise) in the first direction D1, and a plurality of gate structures 170 may be spaced apart from each other in the second direction D2. For example, two gate structures 170 spaced apart from each other in the second direction D2 may extend through an upper portion of an active pattern row of the active patterns 105. The active pattern 105 extending (e.g., lengthwise) in the third direction D3 may include a central portion between the two gate structures 170 adjacent to each other in the second direction D2, and end portions (e.g., opposite end portions) each of which may be disposed at a side of a corresponding one of the two gate structures 170 opposite to the central portion.

In example embodiments, a lower surface of the gate structure 170 may be higher than a lower surface of the isolation pattern 110, e.g., relative to a bottom of the substrate 100.

The conductive filling pattern 255 may be disposed on the central portion of the active pattern 105, a portion of the isolation pattern 110 adjacent to the active pattern 105 in the first direction D1, and a portion of the gate structure 170 adjacent to the active pattern 105 in the second direction D2. The conductive filling pattern 255 may contact sidewalls facing each other in the second direction D2 of two gate structures 170 extending through the upper portion of each of the active patterns 105, i.e., sidewalls of the gate masks 160 facing each other in the second direction D2 of each of the active patterns 105. In example embodiments, a plurality of conductive filling patterns 255 may be spaced apart from each other in the first and second directions D1 and D2. The conductive filling pattern 255 may include, e.g., a metal, a metal nitride, etc.

The first ohmic contact pattern may be disposed between the impurity region at the upper portion of the active pattern 105 and the conductive filling pattern 255. For example, the first ohmic contact pattern may include a metal silicide, e.g., titanium silicide, cobalt silicide, nickel silicide, etc.

The first insulation pattern structure 235 may be formed on the isolation pattern 110 and the gate structure 170 adjacent thereto in the second direction D2. In example embodiments, a plurality of first insulation pattern structures 235 may be spaced apart from each other in the first and second directions D1 and D2.

The first insulation pattern structure 235 may include first, second and third insulation patterns 205, 215 and 225 sequentially stacked in the vertical direction. The first and third insulation patterns 205 and 225 may include an oxide, e.g., silicon oxide, and the second insulation pattern 215 may include an insulating nitride, e.g., silicon nitride.

The bit line structure 355 may include an adhesive pattern 305, a third conductive pattern 315, a first mask 325, a first etch stop pattern 335, and a capping pattern 345 sequentially stacked in the vertical direction on the conductive filling pattern 255 or the first insulation pattern structure 235. The first mask 325, the first etch stop pattern 335, and the capping pattern 345 may collectively form a second insulation pattern structure.

For example, the adhesive pattern 305 may include a metal nitride, e.g., titanium nitride, or a metal silicon nitride, e.g., titanium silicon nitride, the third conductive pattern 315 may include a metal, e.g., tungsten, and each of the first mask 325, the first etch stop pattern 335, and the capping pattern 345 may include an insulating nitride, e.g., silicon nitride. In some embodiments, the first mask 325, the first etch stop pattern 335, and the capping pattern 345 may include substantially the same material so as to be merged with each other, and accordingly, the first insulation pattern structure may have a single layer structure.

In example embodiments, the bit line structure 355 may extend in the second direction D2 on the substrate 100. A plurality of bit line structures 355 may be spaced apart from each other in the first direction D 1.

The spacer structure 395 may include a first spacer 360, an air spacer 375, and a third spacer 380 sequentially stacked in the first direction D1 on each of opposite sidewalls of the bit line structure 355 in the first direction D1.

The first spacer 360 may cover each of opposite sidewalls of the bit line structure 355 in the first direction D1 and upper surfaces of the conductive filling pattern 255 and the third insulation pattern 225, and accordingly, a cross section in the first direction D1 of the first spacer 360 may have an "L" shape. The air spacer 375 may be disposed on an outer sidewall of the first spacer 360. The third spacer 380 may be disposed on an outer sidewall of the air spacer 375, sidewalls of the conductive filling pattern 255 and the first insulation pattern structure 235, and upper surfaces of the active pattern 105, the isolation pattern 110, and the gate structure 170. In example embodiments, uppermost surfaces of the air spacer 375 and the third spacer 380 may be lower than an uppermost surface of the first spacer 360.

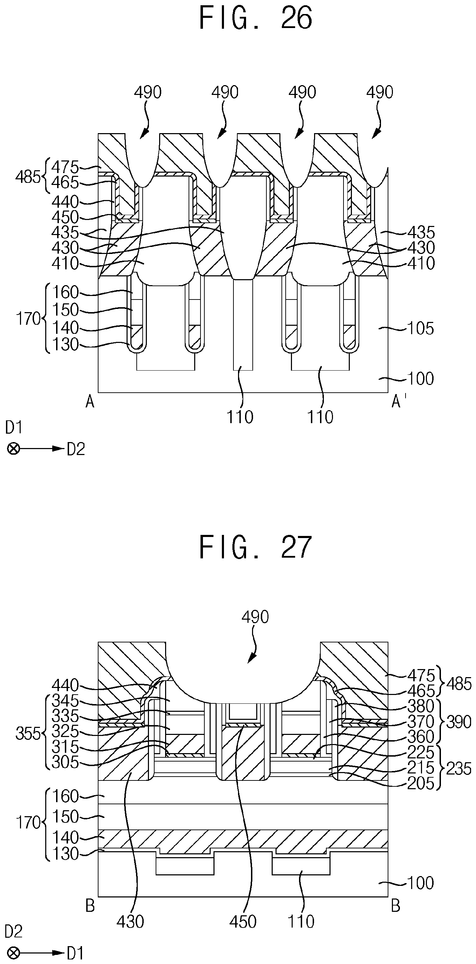

For example, each of the first and third spacers 360 and 380 may include an insulating nitride, e.g., silicon nitride, and the air spacer 375 may include air. In another example, instead of the air spacer 375 containing air, the spacer structure 395 may include a second spacer 370 (refer to FIG. 27) containing an oxide, e.g., silicon oxide.

The fourth spacer 440 may cover an upper outer sidewall of the first spacer 360, a top end of the air spacer 375, and an upper surface and an upper outer sidewall of the third spacer 380. The fourth spacer 440 may be further formed on each of opposite upper sidewalls in the second direction D2 of the first and second fence patterns 410 and 435. For example, the fourth spacer 440 may include an insulating nitride, e.g., silicon nitride.

The contact plug structure may include a lower contact plug 430, a second ohmic contact pattern 450, and an upper contact plug 485 sequentially stacked on the active pattern 105, the isolation pattern 110, and the gate structure 170 in the vertical direction.

The lower contact plug 430 may be disposed between the spacer structures 395 on respective sidewalls of ones of the bit line structures 355 neighboring in the first direction D1. In example embodiments, a plurality of lower contact plugs 430 may be spaced apart from each other in the second direction D2, e.g., in a space between two adjacent bit line structures 355.

The lower contact plugs 430 may be disposed on end portions, respectively, of the active pattern 105, and may contact the impurity regions, respectively, at the upper portions of the active patterns 105.

A distance in the second direction D2 between respective end portions of first ones of the active patterns 105 adjacent to each other in the third direction D3 may be smaller than a distance between respective end portions of second ones of the active patterns 105 adjacent to each other in the first direction D1, which may face each other in the second direction D2. Accordingly, a distance between lower surfaces of the lower contact plugs 430 contacting upper surfaces of end portions of third ones of the active patterns 105 disposed in the second direction D2 may not be constant.

For example, referring to FIG. 1, since distances between adjacent active patterns 105 in the first direction D1 are different from distances between adjacent active patterns 105 in the third direction D3, adjacent lower contact plugs 430 in the second direction D2 overlap different area sizes between adjacent active patterns 105. For example, if one lower contact plug 430 contacts and overlaps a region between adjacent active patterns 105 in the first direction D1, an immediately adjacent lower contact plug 430 in the second direction D2 contacts and overlaps a region between adjacent active patterns 105 in the third direction D3 (which has a different size from the one between adjacent active patterns 105 in the first direction D1). As such, distances between lower surfaces of adjacent lower contact plugs 430 in the second direction D2 may not be constant, as illustrated in FIG. 2.

However, as further illustrated in FIG. 2, in example embodiments, a distance between upper surfaces of the lower contact plugs 430 disposed in the second direction D2 may be constant. For example, a distance between upper surfaces of adjacent lower contact plugs 430 in the second direction D2 may be formed to be constant by adjusting the structures and shapes of the first and second fence patterns 410 and 435 (between respective ones of adjacent lower contact plugs 430), as will be discussed in more detail below.

In detail, lower portions of opposite sidewalls in the second direction D2 of each of the lower contact plugs 430 may not be perpendicular to the upper surface of the substrate 100, and slopes thereof may have the same direction. That is, both of the lower portions of the opposite sidewalls in the second direction D2 of each of the lower contact plugs 430 may have either a positive slope or a negative slope with respect to the upper surface of the substrate 100. The terms "positive slope" and "negative slope" may represent the change in the position along the second direction D2 relative to the position along the vertical direction (e.g. the gradient of the respective sidewall). A positive slope may result in the sidewall being aligned such that its position along the second direction D2 increases as a distance from the substrate 100 along the vertical direction increases. A negative slope may result in the sidewall being aligned such that its position along the second direction D2 decreases as a distance from the substrate 100 along the vertical direction increases.

In example embodiments, the lower contact plugs 430 respectively disposed on the end portions of the first ones of the active patterns 105 adjacent to each other in the third direction D3 may be symmetrical to each other with respect to a reference plane extending in the first direction D1 and the vertical direction, and the lower contact plugs 430 respectively disposed on the end portions of the second ones of the active patterns 105 adjacent to each other in the first direction D1, which may face each other in the second direction D2, may be symmetrical to each other with respect to a reference plane extending in the first direction D1 and the vertical direction. For example, referring to FIG. 2, alternating ones of the lower contact plugs 430 may be sloped in a same direction, and adjacent ones of the lower contact plugs 430 may be sloped in opposite directions and symmetrical to each other with respect to a reference plane extending in the vertical direction.

Accordingly, lower portions of opposite sidewalls in the second direction D2 of the lower contact plugs 430 respectively formed on the end portions of the first ones of the active patterns 105 adjacent to each other in the third direction D3 may have slopes with different directions from each other (e.g., one may have a positive slope and the other may have a negative slope). Also, lower portions of opposite sidewalls in the second direction D2 of the lower contact plugs 430 respectively formed on the end portions of the second ones of the active patterns 105 adjacent to each other in the first direction D1, which may face each other in the second direction D2, may have slopes with different directions from each other (e.g., one may have a positive slope and the other may have a negative slope).

The first and second fence patterns 410 and 435 may be formed between the spacer structures 395 on the opposite sidewalls, respectively, of the bit line structures 355 adjacent to each other in the first direction D1. The first and second fence patterns 410 and 435 may be alternately and repeatedly disposed along the second direction D2, and may separate the lower contact plugs 430 from each other.

The first fence pattern 410 may be formed on a portion of the isolation pattern 110 disposed between the central portions of the active patterns 105 adjacent to each other in the first direction D1, and may also be formed on portions of the active pattern 105 and the gate structure 170 adjacent thereto.

In example embodiments, the first fence pattern 410 may include first to third portions sequentially stacked in the vertical direction on the isolation pattern 110. The first portion of the first fence pattern 410 may be formed on the isolation pattern 110 (e.g., rounded portion directly on the isolation pattern 110 that curves toward the gate structure 170), and a first width in the second direction D2 of first portion of the first fence pattern 410 may increase as a distance from the substrate 100 in the vertical direction increases. The second portion of the first fence pattern 410 may be formed on the first portion (e.g., a portion above the gate structures 170 that horizontally overlaps the lower contact plugs 430), and a second width in the second direction D2 of the second portion of the first fence pattern 410 may decrease as a distance from the substrate 100 in the vertical direction increases. The third portion of the first fence pattern 410 may be formed on the second portion (e.g., a portion horizontally overlapping the upper contact plug 485), and a third width of the third portion of the first fence pattern 410 may be substantially constant along the second direction D2.

The second fence pattern 435 may be formed on a portion of the isolation pattern 110 between the end portions of the first ones of the active patterns 105 adjacent to each other in the third direction D3, and may also be formed on portions of the first ones of the active pattern 105 adjacent thereto.

In example embodiments, a width of the second fence pattern 435 in the second direction D2 may increase and then be substantially constant as a distance from the substrate 100 in the vertical direction increases. In example embodiments, a lower surface of the second fence pattern 435 may be lower than a lower surface of the lower contact plug 430, e.g., a distance from a lower surface of the second fence pattern 435 to the bottom of the substrate 100 may be smaller than a distance from a lower surface of the lower contact plug 430 to the bottom of the substrate 100.

For example, each of the first and second fence patterns 410 and 435 may include an oxide, e.g., silicon oxide, or an insulating nitride, e.g., silicon nitride. The first and second fence patterns 410 and 435 may include substantially the same material or different materials from each other.

The second ohmic contact pattern 450 may be disposed on the lower contact plug 430. For example, the second ohmic contact pattern 450 may include a metal silicide, e.g., titanium silicide, cobalt silicide, nickel silicide, etc.

The upper contact plug 485 may include a third metal pattern 475 and a barrier pattern 465 covering a lower surface thereof. The upper contact plug 485 may be disposed on the second ohmic contact pattern 450, the bit line structure 355, the first and second fence patterns 410 and 435, and the fourth spacer 440. In example embodiments, the upper contact plug 485 may include a lower portion at a height lower than upper surfaces of the first and second fence patterns 410 and 435 (e.g., relative to a bottom of the substrate 100), and an upper portion at a height higher than the upper surfaces of the first and second fence patterns 410 and 435. A distance in the second direction D2 between lower portions of ones of the upper contact plugs 485 disposed in the second direction D2 may be substantially constant.

In example embodiments, the upper contact plug 485 may have any suitable shape in a plan view, e.g., a circle, an ellipse, a polygon, a polygon with rounded corners, etc. For example, the upper contact plugs 485 may be arranged in a honeycomb pattern in the first and second directions D1 and D2, as viewed in a plan (e.g., top) view.

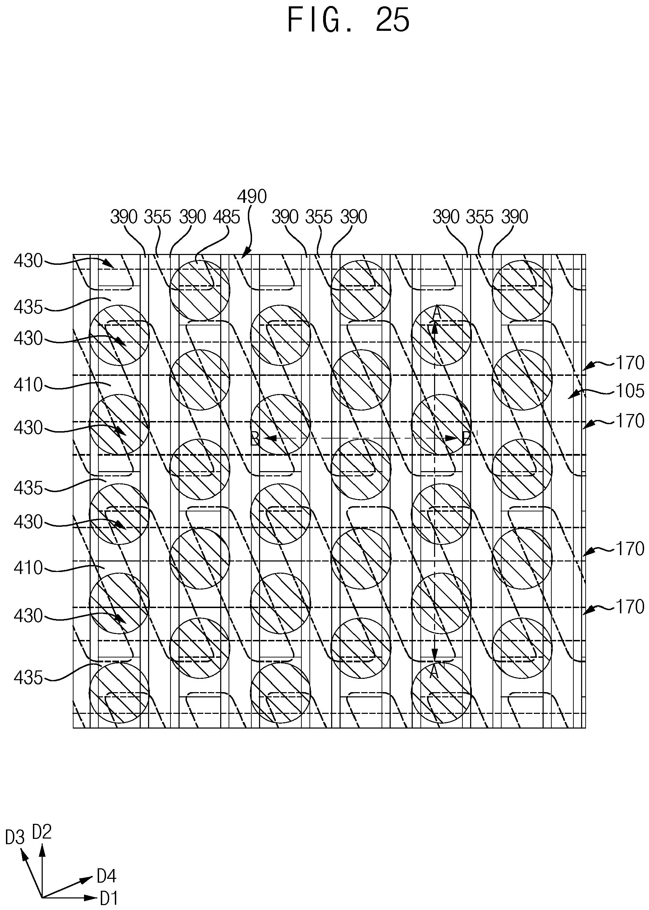

Referring to FIGS. 1 to 3 together with FIGS. 25 to 27, the third insulation pattern structure 520 may include a fourth insulation pattern 500 on an inner wall of a seventh opening 490, which may extend through the upper contact plug 485 and portions of the second insulation pattern structure included in the bit line structure 355, the spacer structure 395 and the fourth spacer 440, and surround the upper contact plug 485 in a plan view, and a fifth insulation pattern 510, which may be disposed on the fourth insulation pattern 500 and fill a remaining portion of the seventh opening 490. An upper end of the air spacer 375 may be closed by the fourth insulation pattern 500. For example, the fourth and fifth insulation patterns 500 and 510 may include an insulating nitride, e.g., silicon nitride.

The second etch stop layer 530 may be disposed on the third insulation pattern structure 520 and the upper contact plug 485. For example, the second etch stop layer 530 may include an insulating nitride, e.g., silicon boronitride, silicon nitride, etc.

The capacitor 570 may include a lower electrode 540, a dielectric layer 550, and an upper electrode 560 sequentially stacked. The lower electrode 540 may extend through the second etch stop layer 530, and may contact an upper surface of the upper contact plug 485.

Each of the lower electrode 540 and the upper electrode 560 may include, e.g., a metal, a metal nitride, a metal silicide, etc. The dielectric layer 550 may include, e.g., a metal oxide.

In the semiconductor device, although the distance in the second direction D2 between the lower surfaces of the lower contact plugs 430 disposed in the second direction D2 may not be constant, the distance in the second direction D2 between the upper surfaces of the lower contact plugs 430 may be substantially constant. Accordingly, the difficulty of forming the upper contact plugs 485 on the lower contact plugs 430, respectively, may be substantially reduced.

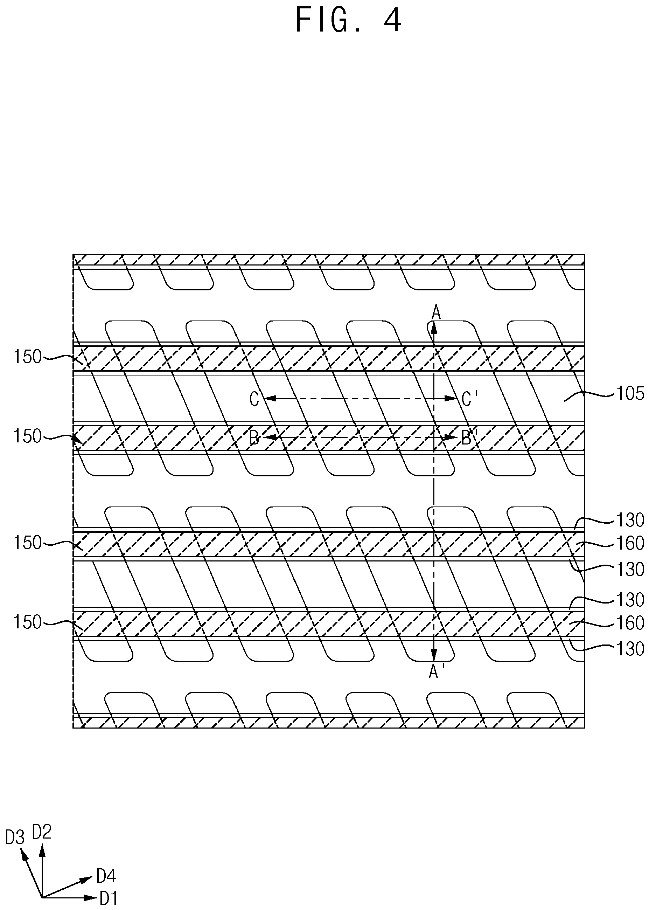

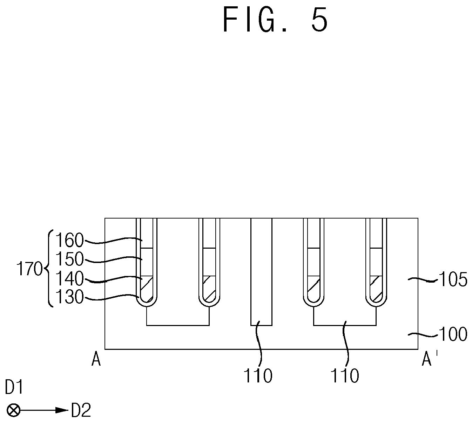

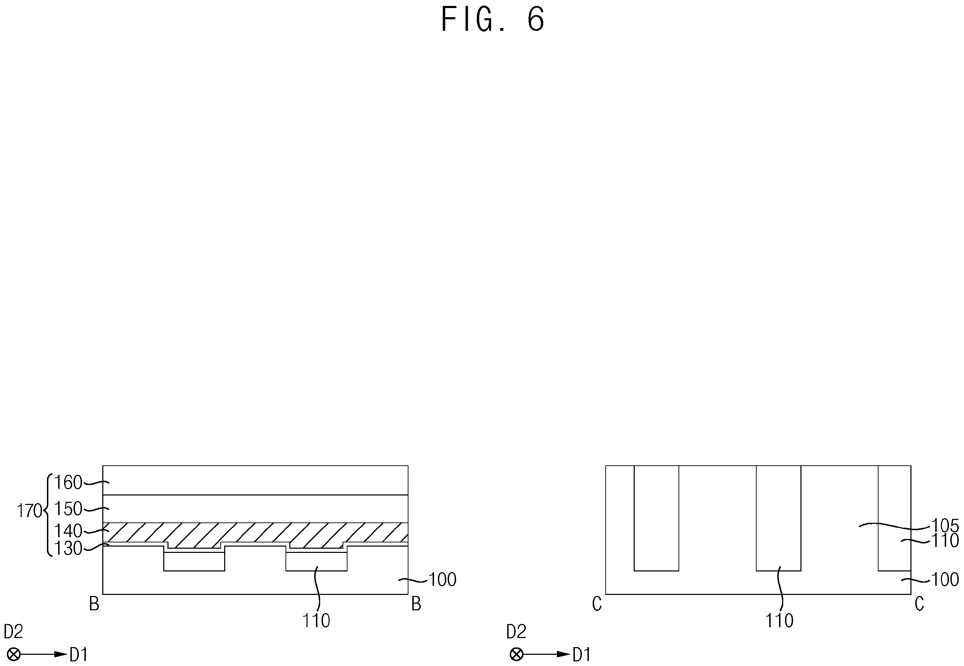

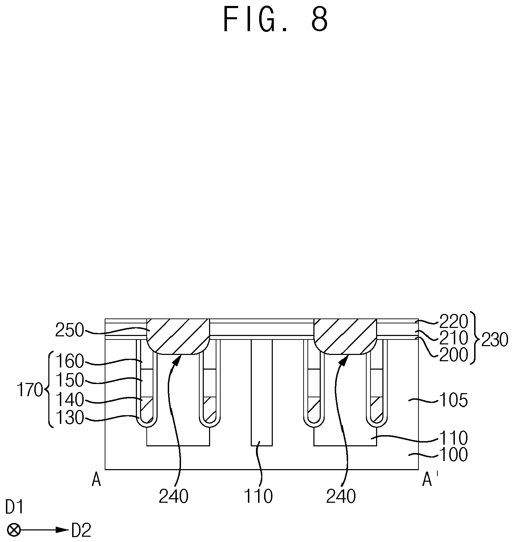

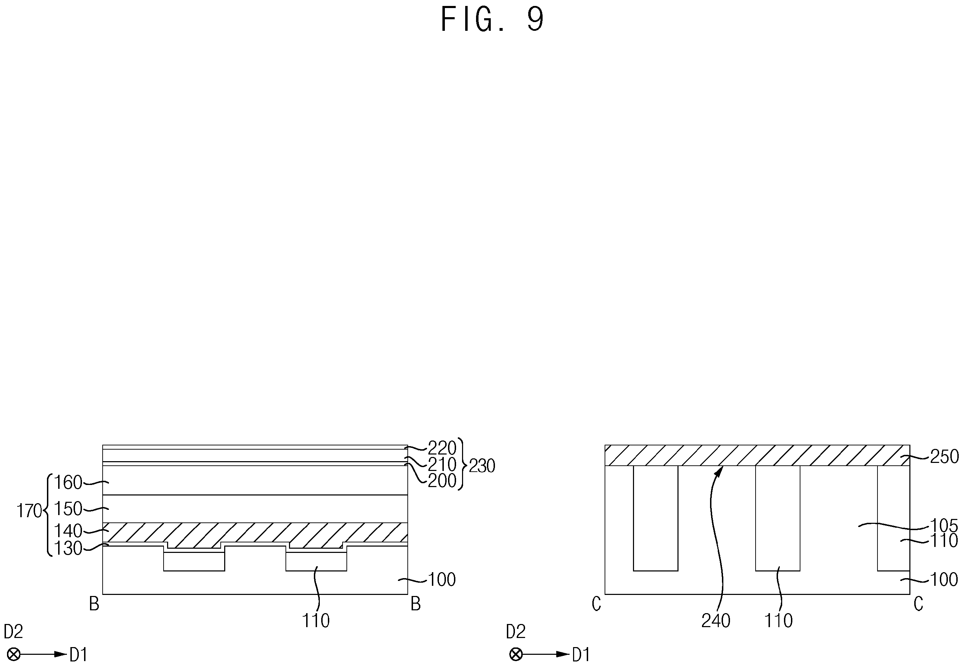

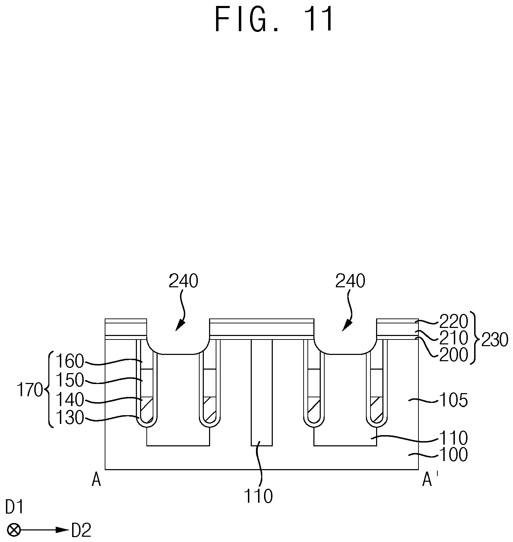

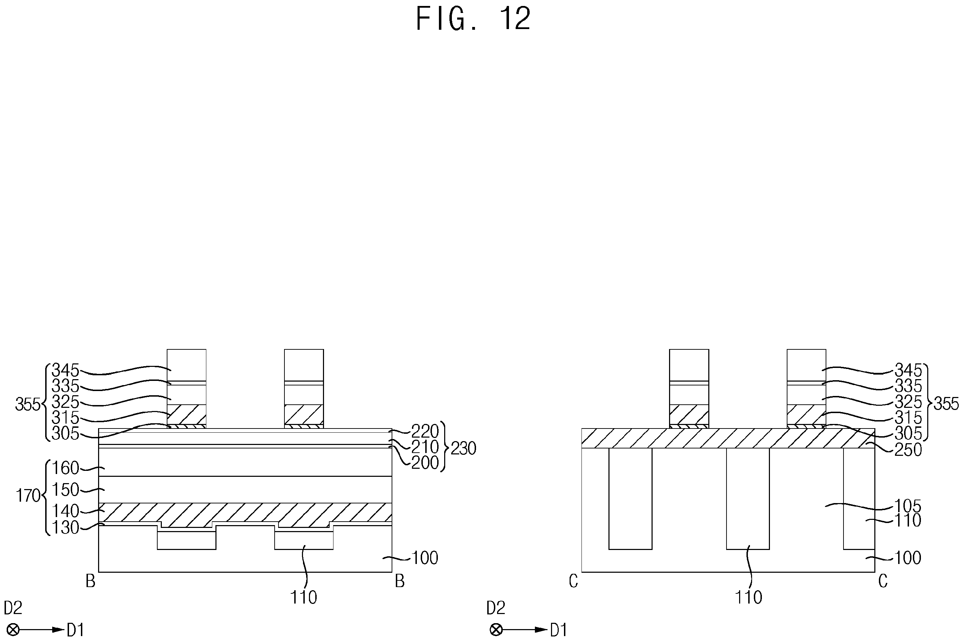

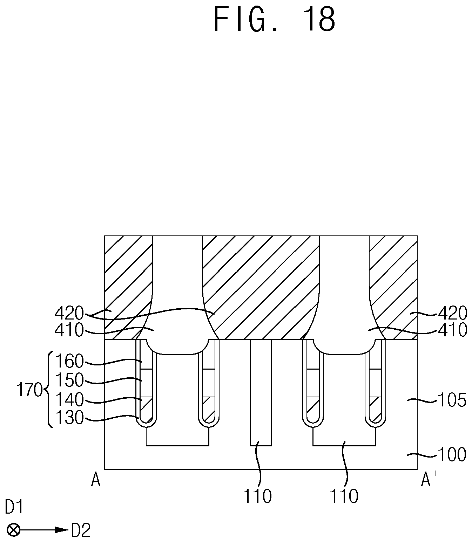

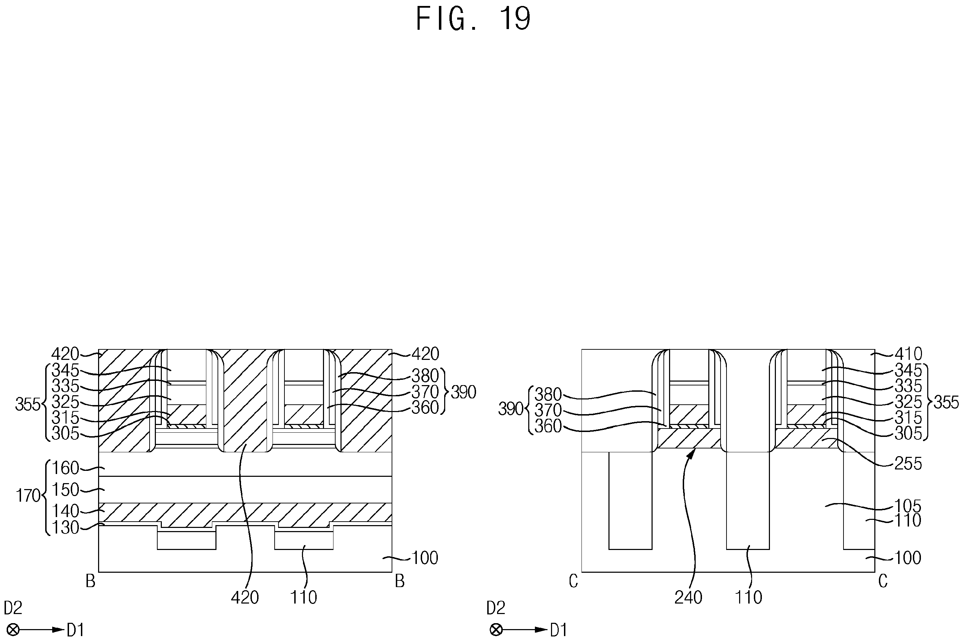

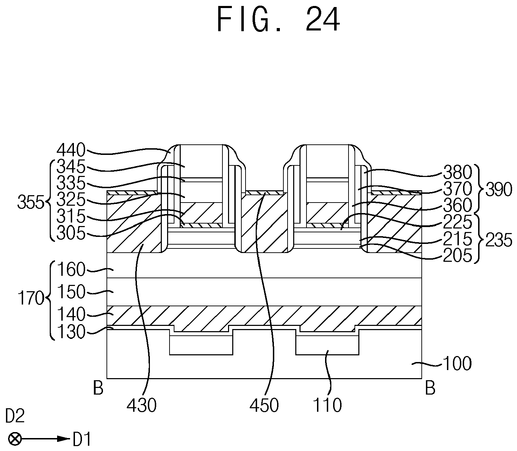

FIGS. 4 to 29 are plan views and cross-sectional views of stages in a method of manufacturing a semiconductor device in accordance with example embodiments. FIGS. 4, 7, 10, 17, 21 and 25 are the plan views, FIGS. 5, 8, 11, 13, 15, 18, 20, 22-23, 26 and 28 are cross-sectional views taken along lines A-A' of corresponding plan views, respectively, FIGS. 6, 9, 12, 14, 16 and 19 include cross-sectional views taken along lines B-B' and C-C' of corresponding plan views, respectively, and FIGS. 24, 27 and 29 are cross-sectional views taken along lines B-B' of corresponding plan views, respectively,

Referring to FIGS. 4 to 6, an upper portion of the substrate 100 may be removed to form a first recess, and the isolation pattern 110 may be formed to fill the first recess. As the first recess is formed on the substrate 100, the active pattern 105 whose sidewall is covered by the isolation pattern 110 may be defined on the substrate 100.

In example embodiments, the active pattern 105 may extend by a certain length in the third direction D3, and a plurality of active patterns 105 may be spaced apart from each other in the first and third directions D1 and D3 to define an active pattern array. The active pattern array may include an active pattern row including active patterns 105 disposed in the first direction D1, and a plurality of active pattern rows may be spaced apart from each other in the second direction D2. The active patterns 105 included in the active pattern rows, respectively, adjacent to each other in the second direction D2 may face each other in the third direction D3.

An impurity region may be formed at an upper portion of the active pattern 105 by doping, e.g., n-type impurities or p-type impurities into the upper portion of the active pattern 105. In example embodiments, the impurity region may be formed by a gas phase doping (GPD) process.

An upper portion of the active pattern 105 having the impurity region and the isolation pattern 110 may be partially etched to form a second recess.

In example embodiments, the second recess may extend in the first direction D1, and a plurality of second recesses may be spaced apart from each other in the second direction D2. A bottom of each of the second recesses may be higher than a bottom surface of the isolation pattern 110.

In example embodiments, two second recesses spaced apart from each other in the second direction D2 may be formed on each of the active patterns 105. Hereinafter, a portion of the active pattern 105 extending in the third direction D3 (which may be disposed between the second recesses) may be referred to as a central portion of the active pattern 105, and portions of the active pattern 105 (each of which may be disposed at a side of a corresponding one of the second recesses opposite to the central portion) may be referred to as end portions of the active pattern 105.

The gate structure 170 may be formed in the second recess. A gate insulation layer may be formed on an inner wall of the second recess, an upper surface of the active pattern 105 and an upper surface of the isolation pattern 110, first and second conductive patterns 140 and 150 may be formed to fill a lower portion and an upper portion of the second recess, respectively, a gate mask layer may be formed on the second conductive pattern 150 and the gate insulation layer to fill an upper portion of the second recess, and the gate mask layer and the gate insulation layer may be planarized until the upper surfaces of the active pattern 105 and the isolation pattern 110 are exposed to form the gate mask 160 and the gate insulation pattern 130, respectively. The gate insulation pattern 130, the first and second conductive patterns 140 and 150, and the gate mask 160 may collectively form the gate structure 170. The planarization process may include, e.g., a chemical mechanical polishing (CMP) process and/or an etch back process.

In example embodiments, the gate structure 170 may extend in the first direction D1 on the substrate 100. A plurality of gate structures 170 may be spaced part from each other in the second direction D2.

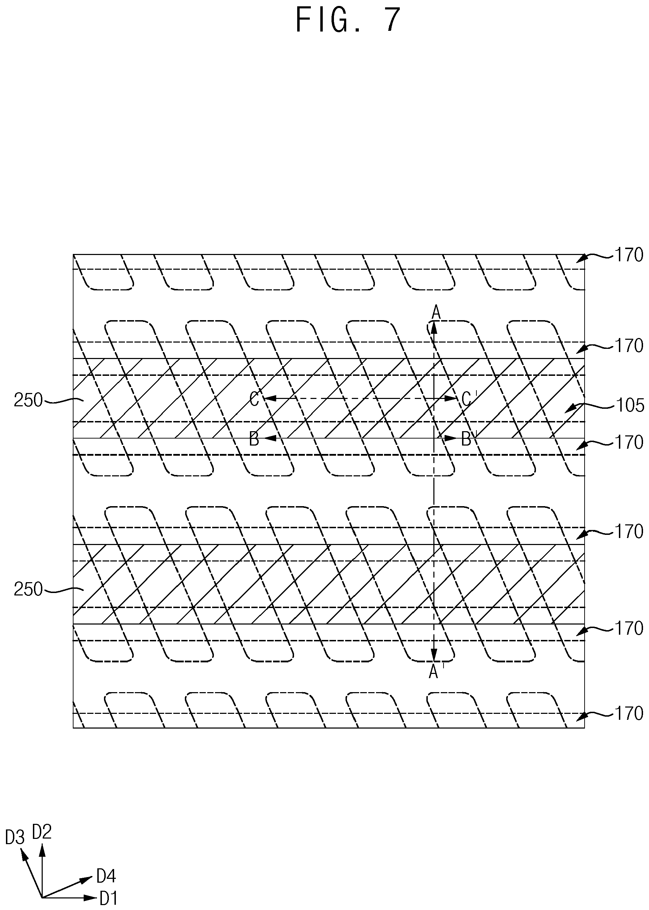

Referring to FIGS. 7 to 9, the first insulating layer structure 230 may be formed on the active pattern 105, the isolation pattern 110, and the gate structure 170. The first insulating layer structure 230 may be patterned, and the active pattern 105, the isolation pattern 110, and an upper portion of the gate structure 170 may be partially etched by using the patterned first insulating layer structure 230 as an etching mask to form a first opening 240.

In example embodiments, the first opening 240 may extend in the first direction D1, and a plurality of first openings 240 may be spaced apart from each other in the second direction D2. Each of the first openings 240 may overlap the central portions of ones of the active patterns 105 disposed in the first direction D1 in a vertical direction substantially perpendicular to the upper surface of the substrate 100, and may have a width in the second direction D2 greater than a width in the second direction D2 of the central portions of the ones of the active patterns 105.

Accordingly, each of the first openings 240 may expose the upper surfaces of the central portions of the ones of the active patterns 105 disposed in the first direction D 1, upper surfaces of portions of the gate insulation pattern 130 and the gate mask adjacent thereto in the second direction D2, and upper surfaces of the isolation pattern 110 adjacent to the central portions of the ones of the active patterns 105 in the first direction D1.

A first conductive filling layer 250 may be formed to fill the first opening 240. In an example embodiment, before forming the first conductive filling layer 250, first ohmic contact patterns may be formed on the central portions, respectively, of the active patterns 105 exposed by the first opening. In example embodiments, a plurality of first ohmic contact patterns may be spaced apart from each other in the first and second directions D1 and D2.

The first conductive filling layer 250 may be formed by forming a third conductive layer on the first ohmic contact pattern and the first insulating layer structure 230 to fill the first opening 240, and performing a planarization process on the third conductive layer until the upper surface of the first insulating layer structure 230 is exposed. In example embodiments, the first conductive filling layer 250 may extend in the first direction D1, and a plurality of first conductive filling layers 250 may be spaced apart from each other in the second direction D2.

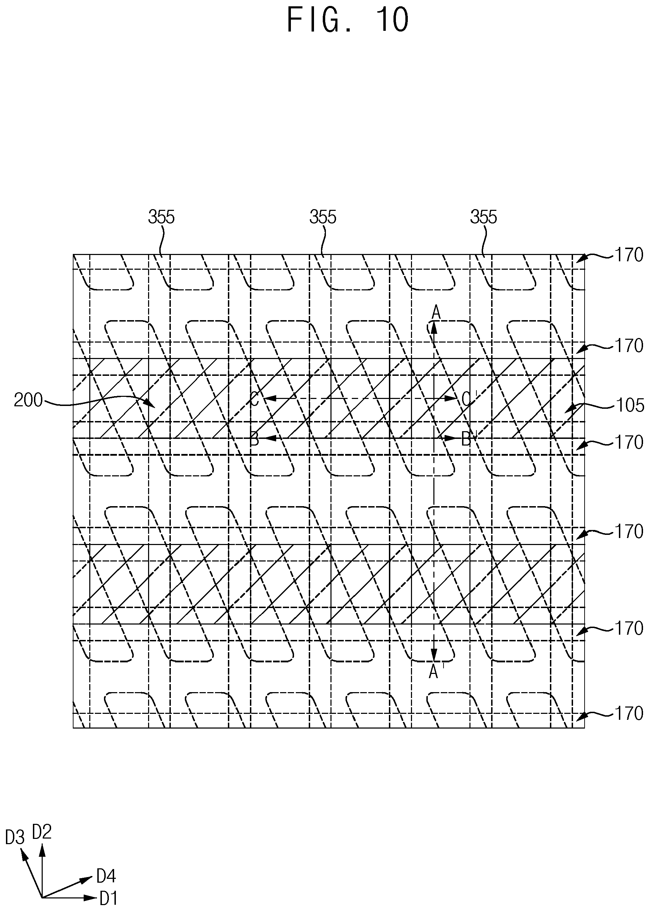

Referring to FIGS. 10 to 12, an adhesive layer, a fourth conductive layer, a first mask layer, a first etch stop layer and a capping layer may be sequentially stacked on the first insulating layer structure 230 and the first conductive filling layer 250. The capping layer may be etched to form a capping pattern 345, and the first etch stop layer, the first mask layer, the fourth conductive layer and the adhesive layer may be sequentially etched by performing an etching process using the capping pattern 345 as an etch mask.

The adhesive pattern 305, the third conductive pattern 315, the first mask 325, the first etch stop pattern 335 and the capping pattern 345 may be sequentially stacked on the first insulating layer structure 230 and the first conductive filling layer 250, which may collectively form the bit line structure 355. The first mask 325, the first etch stop pattern 335 and the capping pattern 340 may collectively form a second insulation pattern structure. In example embodiments, the bit line structure 355 may extend in the second direction D2 on the first conductive filling layer 250 and the conductive filling pattern 255, and a plurality of bit line structures 355 may be spaced apart from each other in the first direction D1.

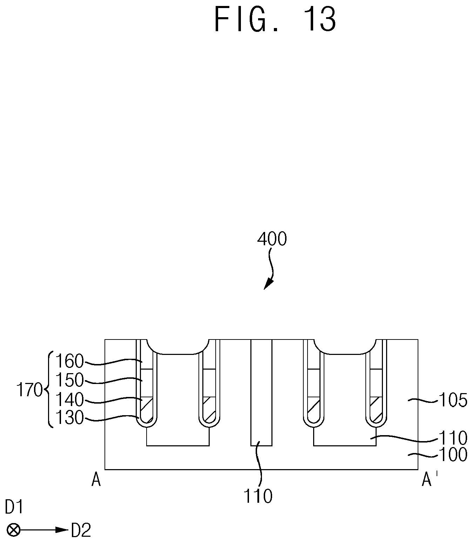

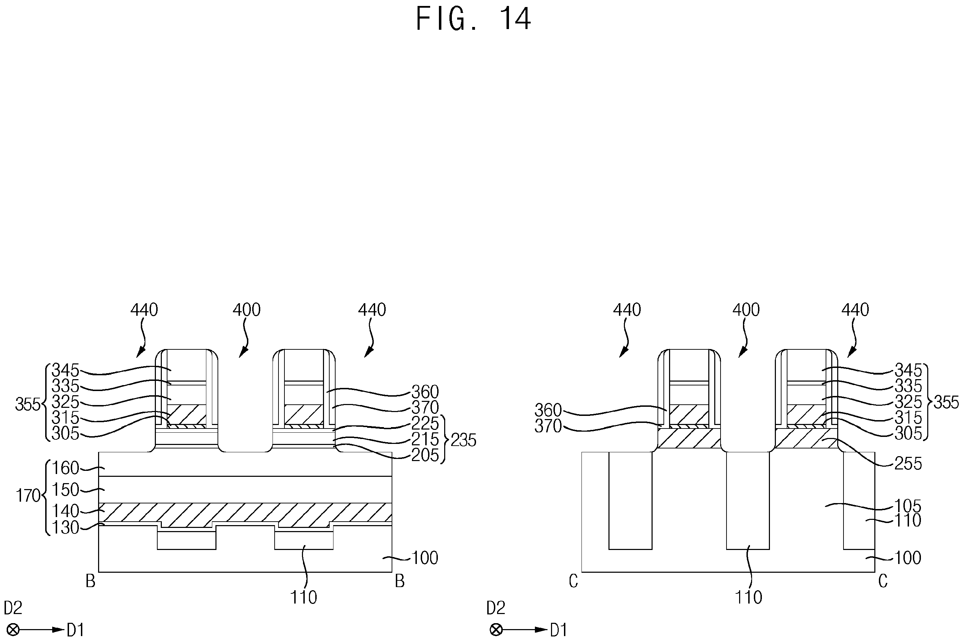

Referring to FIGS. 13 and 14, a first spacer layer may be formed on the bit line structure 355, the first conductive filling layer 250 and the first insulating layer structure 230, and a second spacer layer may be formed on the first spacer layer.

An anisotropic etching process may be performed on the first and second spacer layers to form the first and second spacers 360 and 370, respectively, which may be stacked along the first direction D1 on a sidewall of the bit line structure 355 in the first direction D1. A cross-section of the first spacer 360 in the first direction D1 may have an "L" shape.

A dry etching process may be performed using the bit line structure 355 and the first and second spacers 360 and 370 as an etch mask to etch the first insulating layer structure 230 and the first conductive filling layer 250 to form a second opening 400 exposing the upper surfaces of the active pattern 105, the isolation pattern 110, and the gate structure 170. In example embodiments, the second opening 400 may extend in the second direction D2, and a plurality of second openings 400 may be spaced apart from each other in the first direction D1.

During the dry etching process, the conductive filling layer 250 extending in the first direction D1 may be separated into a plurality of conductive filling patterns 255 spaced apart from each other in the first direction D1, and the first insulating layer structure 230 extending in the first direction D1 may be separated into a plurality of first insulation pattern structures 235 spaced apart from each other in the first direction D1. Each of the conductive filling patterns 255 and each of the first insulation pattern structures 235 may be formed under the bit line structure 355 and the first and second spacers 360 and 370. The first insulation pattern structure 235 may include the first to third insulation patterns 205, 215, and 225 sequentially stacked in the vertical direction

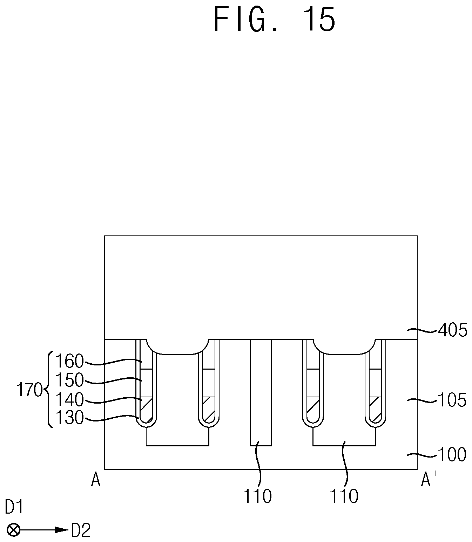

Referring to FIG. 15 to 16, a third spacer layer may be formed on the bit line structure 355, the first and second spacers 360 and 370, the conductive filling pattern 255, the first insulation pattern structure 235, and the active pattern 105, the isolation pattern 110 and the gate structure 170 exposed by the second opening 400, and an anisotropic etching process may be performed on the third spacer layer to form the third spacer 380 covering an outer sidewall of the second spacer 370, a sidewall of the conductive filling pattern 255, and a sidewall of the first insulation pattern structure 235. Accordingly, a preliminary spacer structure 390 including the first to third spacers 360, 370 and 380 sequentially stacked in the first direction D1 may be formed on the sidewall of the bit line structure 355 in the first direction D 1.

A first fence layer 405 may be formed to a sufficient height on the bit line structure 355, the preliminary spacer structure 390, the active pattern 105, and the isolation pattern 110, and may be planarized until an upper surface of the bit line structure 355 is exposed. In example embodiments, the first fence layer 405 may extend (e.g., lengthwise) in the second direction D2, and a plurality of first fence layers 405 may be spaced apart from each other in the first direction D1 by the bit line structures 355.

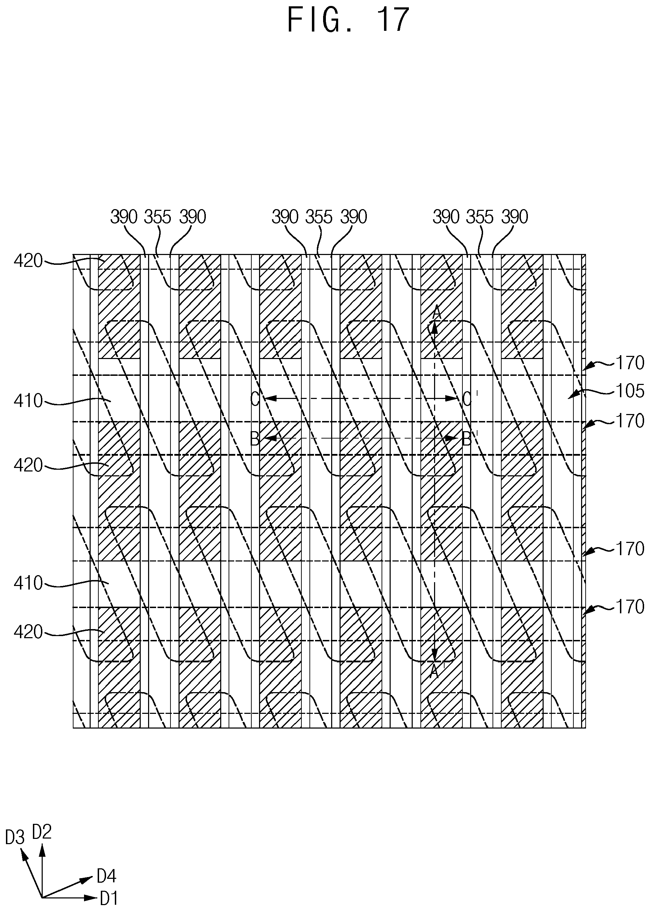

Referring to FIGS. 17 to 19, a second mask having a plurality of third openings spaced apart from each other in the second direction D2, each of which may extend in the first direction D1, may be formed on the bit line structure 355, the preliminary spacer structure 390 and the first fence layer 405, and the first fence layer 405 may be etched by using the second mask as an etching mask to form fourth openings.

In example embodiments, the fourth openings may expose upper surfaces of end portions of ones of the active patterns 105 adjacent to each other in the third direction D3, which may face each other, and a portion of the isolation pattern 110 therebetween. In some cases, a portion of the upper surface of the gate structure 170 may also be exposed by the fourth openings.

The first fence layer 405 extending in the second direction D2 between the bit line structures 355 may be separated into a plurality of first fence patterns 410 spaced apart from each other in the second direction D2 by the fourth openings.

After removing the second mask, a lower contact plug layer filling the fourth openings may be formed to a sufficient height, and an upper portion of the lower contact plug layer may be planarized until the upper surface of the bit line structure 355 is exposed. Accordingly, a plurality of preliminary lower contact plugs 420 may be formed between the bit line structures 355 adjacent to each other in the first direction D1. The plurality of preliminary lower contact plugs 420 may be spaced apart from each other in the second direction D2 by the first fence patterns 410. In example embodiments, each of the preliminary lower contact plugs 420 may contact upper surfaces of the end portions of the active patterns 105 adjacent to each other and facing each other in the third direction D3 and an upper surface of the portion of the isolation pattern 110 therebetween.

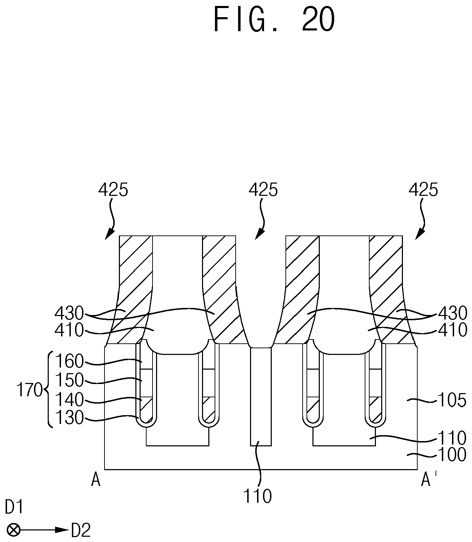

Referring to FIG. 20, a third mask including a plurality of fifth openings, each of which may extend in the first direction D1, spaced apart from each other in the second direction D2, may be formed on the bit line structure 355, the preliminary spacer structure 390, the first fence pattern 410 and the preliminary lower contact plug 420, and the preliminary lower contact plug 420 may be etched to form a sixth opening 425 by performing a second etching process using the third mask as an etch mask.

In example embodiments, each of the sixth openings 425 may expose the portion of the isolation pattern 110 between the end portions facing each other of the ones of the active patterns 105, which may be adjacent to each other in the third direction D3 and disposed between the bit line structures 355 adjacent to each other in the first direction D1, and a portion of the active pattern 105 adjacent thereto.

Accordingly, each of the preliminary lower contact plugs 420 may be separated into two lower contact plugs 430 spaced apart from each other in the second direction D2 by the sixth opening 425. In example embodiments, each of the lower contact plugs 430 may contact an upper surface of the end portion of a corresponding one of the active patterns 105.

In example embodiments, distances between upper surfaces of ones of the lower contact plugs 430 adjacent to each other in the second direction D2 may be substantially the same as each other. However, distances between lower surfaces of ones of the lower contact plugs 430 adjacent to each other in the second direction may vary. That is, a distance in the second direction D2 between end portions of first ones of the active patterns 105 adjacent to each other in the third direction D3 may be smaller than a distance in the second direction D2 between end portions of second ones of the active patterns 105 adjacent to each other in the first direction D1, and accordingly, lower surfaces of the lower contact plugs 430 contacting upper surfaces of end portions of third ones of the active patterns 105 disposed in the second direction D2 may not be constant. However, in example embodiments, a distance between upper surfaces of the lower contact plugs 430 disposed in the second direction D2 may be substantially constant by adjusting position and width of the sixth opening 425 in the second etching process.

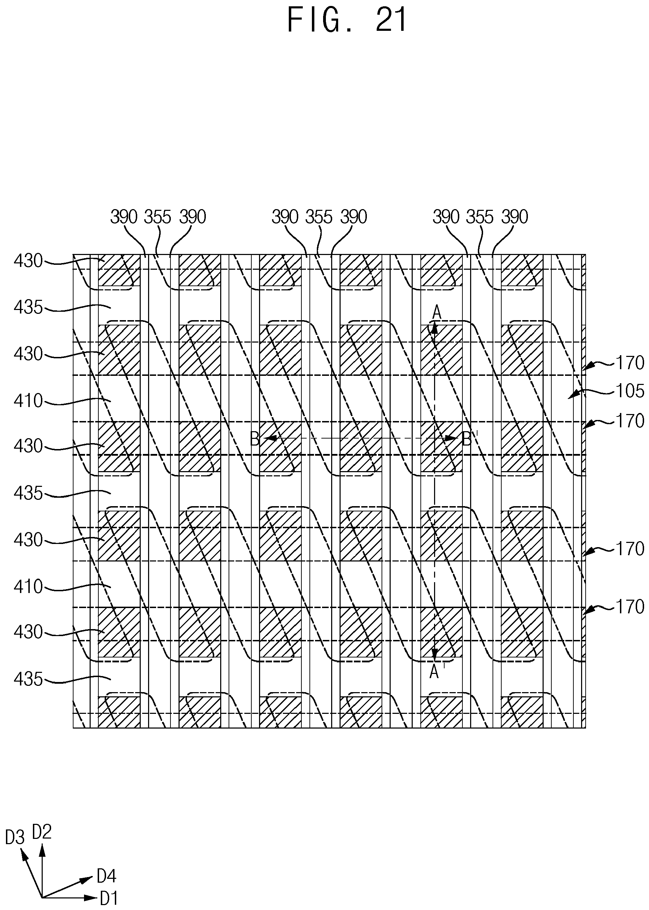

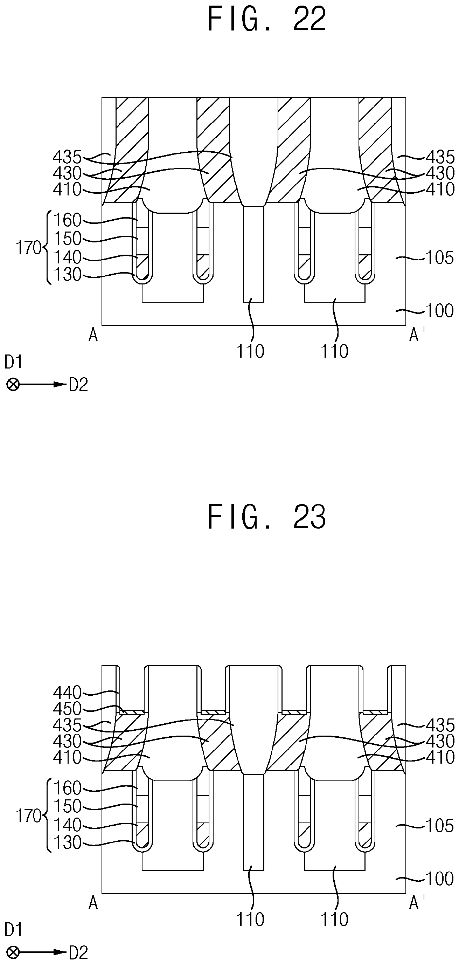

Referring to FIGS. 21 and 22, after removing the third mask, a second fence layer filling the sixth opening 425 may formed to a sufficient height, and an upper portion of the second fence layer may be planarized until the upper surface of the bit line structure 355 is exposed. Accordingly, a plurality of second fence patterns 435 may be formed to be spaced apart from each other along the second direction D2 between the bit line structures 355 adjacent to each other in the first direction D 1.

Referring to FIGS. 23 and 24, an upper portion of the lower contact plug 430 may be partially removed to expose an upper portion of the preliminary spacer structure 390 on the sidewall of the bit line structure 355, and upper portions of the second and third spacers 370 and 380 of the exposed preliminary spacer structure 390 may be removed.

An upper portion of the lower contact plug 430 may be further removed. Accordingly, an upper surface of the lower contact plug 430 may be lower than uppermost surfaces of the second and third spacers 370 and 380.

A fourth spacer layer may be formed on the bit line structure 355, the preliminary spacer structure 390, the first and second fence patterns 410 and 435, and the lower contact plug 430, and may be anisotropically etched to form the fourth spacer 440 covering an upper portion of the preliminary spacer structure 390 on each of opposite sidewalls of the bit line structure 355 in the first direction D1. Thus, the upper surface of the lower contact plug 430 may be exposed. The fourth spacer 440 may also be formed on upper portions of sidewalls in the second direction D2 of the first and second fence patterns 410 and 435.

The second ohmic contact pattern 450 may be formed on the exposed upper surface of the lower contact plug 430. In example embodiments, the second ohmic contact pattern 450 may be formed by forming a first metal layer on the bit line structure 355, the preliminary spacer structure 390, the fourth spacer 440, the first and second fence patterns 410 and 435 and the lower contact plug 430, and performing heat treatment on the first metal layer so that a metal included in the first metal layer and silicon included in the lower contact plug 430 may be reacted with each other, and a portion of the first metal layer that is not reacted with silicon may be removed.

Referring to FIGS. 25 to 27, a barrier layer may be formed on the bit line structure 355, the preliminary spacer structure 390, the fourth spacer 440, the first and second fence patterns 410 and 435 and the second ohmic contact pattern 450, and a second metal layer may be formed on the barrier layer in a space between the bit line structures 355. A planarization process may be further performed on an upper portion of the second metal layer. The planarization process may include, e.g., a chemical mechanical polishing (CMP) process and/or an etch back process.

The second metal layer and the barrier layer may be patterned to form upper contact plugs 485, and the seventh opening 490 may be formed between the upper contact plugs 485. The seventh opening 490 may be formed by partially removing not only the third metal layer and the barrier layer, but also the second insulation pattern structure included in the bit line structure 355, the preliminary spacer structure 390 and the fourth spacer 440.

The upper contact plug 485 may include the third metal pattern 475 and the barrier pattern 465 covering a lower surface thereof. In example embodiments, the upper contact plug 485 may have a shape, e.g., a circle, an ellipse, a polygon, a polygon with rounded corners, etc., and may be arranged, e.g., in a honeycomb pattern in the first and second directions D1 and D2, in a plan view.

The lower contact plug 430, the second ohmic contact pattern 450 and the upper contact plug 485 sequentially stacked on the substrate 100 may collectively form a contact plug structure.

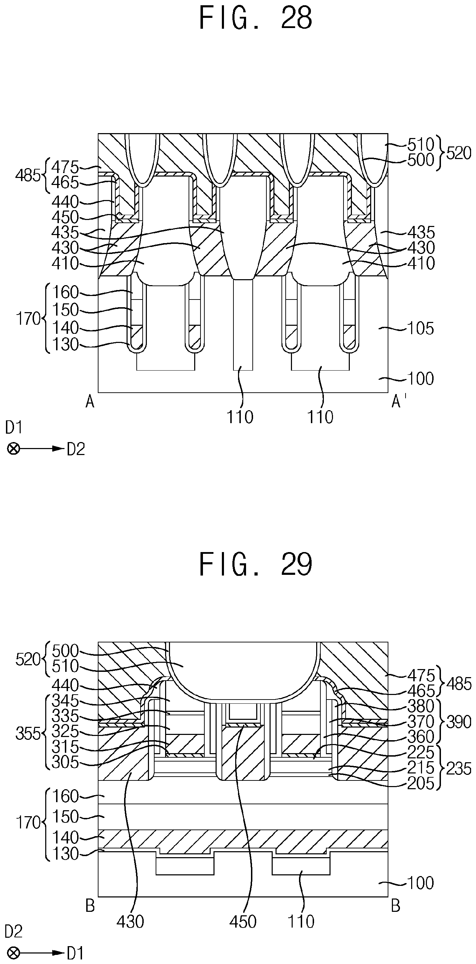

Referring to FIGS. 28 and 29, the second spacer 370 included in the preliminary spacer structure 390 exposed by the seventh opening 490 may be removed to form an air gap, the fourth insulation pattern 500 may be formed on a bottom and a sidewall of the seventh opening 490, and the fifth insulation pattern 510 may be formed in a remaining portion of the seventh opening 490. The fourth and fifth insulation patterns 500 and 510 may collectively form the third insulation pattern structure 520.

An upper end of the air gap may be covered by the fourth insulation pattern 500, so that the air spacer 375 may be formed. The first spacer 360, the air spacer 375, and the third spacer 380 may collectively form the spacer structure 395. However, in some example embodiments, the second spacer 370 may not be removed, and in this case, instead of the spacer structure 395 including the air spacer 375, the preliminary spacer structure 390 including the second spacer 370 may remain.

Referring back to FIGS. 1 to 3, the second etch stop layer 530 and a mold layer may be sequentially formed on the third insulation pattern structure 520 and the upper contact plug 485, an eighth opening may be formed through the mold layer and the second etch stop layer 530 to expose an upper surface of the upper contact plug 485, and a lower electrode 540 may be formed in the eighth opening.

The mold layer may be removed, and the dielectric layer 550 and the upper electrode 560 may be sequentially formed on the lower electrode 540 and the second etch stop layer 530. Thus, the capacitor 570 including the lower electrode 540, the dielectric layer 550, and the upper electrode 560 may be formed, and a fabrication of the semiconductor device may be completed.

As described above, the first etching process may be performed on the first fence layer 405 extending (e.g., lengthwise) in the second direction D2 between the bit line structures 355. Accordingly, the first fence layer 405 may be transformed into the plurality of first fence patterns 410 spaced apart from each other in the first direction D 1, and the fourth opening 415 exposing the upper surfaces of the end portions facing each other of the first ones of the active patterns 105 adjacent to each other in the third direction D3 and the isolation pattern 110 therebetween may be formed between the first fence patterns 410.

Subsequently, preliminary lower contact plugs 420 may be formed to fill the fourth opening 415, and the second etching process may be performed on the preliminary lower contact plugs 420. Accordingly, each of the preliminary lower contact plugs 420 may be transformed into two lower contact plugs 430 spaced apart from each other in the second direction D2, and the sixth opening 425 may be formed to expose the upper surface of the isolation pattern 110 between the end portions facing each other of the first ones of the active patterns 105 adjacent to each other in the third direction D3.

The second fence pattern 435 may be formed in the sixth opening 425, and the upper contact plugs 485 may be formed on the lower contact plugs 430, respectively.

In the semiconductor device, according to example embodiments, the distance in the second direction D2 between the end portions of the first ones of the active patterns 105 adjacent to each other in the third direction D3 may be smaller than the distance in the second direction D2 between the end portions of the second ones of the active patterns 105 adjacent to each other in the first direction D1, which may face each other in the second direction D2. Accordingly, the distance between the lower surfaces of the lower contact plugs 430 contacting the upper surfaces of the end portions of the third ones of the active patterns 105 disposed in the second direction D2 may not be constant. However, in example embodiments, by adjusting the position and width of the sixth opening 425 in the second etching process, the distance between the upper surfaces of the lower contact plugs 430 may be substantially constant. Accordingly, the upper contact plugs 485 may be easily formed on the upper surfaces of the lower contact plugs 430, e.g., when compared to a case in which the distance between the upper surfaces of the lower contact plugs 420 is not constant.

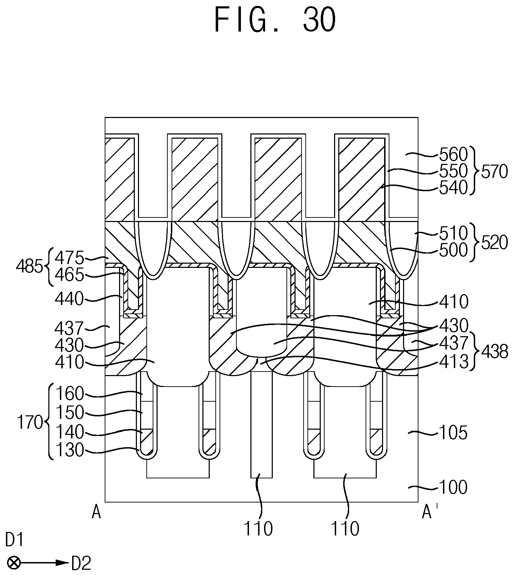

FIG. 30 is a cross-sectional view illustrating a semiconductor device in accordance with example embodiments, which corresponds to FIG. 2. This semiconductor device may be substantially the same as or similar to that of FIGS. 1 to 3, except for the shape of the lower contact plug 430 and further including a first fence structure 438, and thus repeated explanations are omitted herein.

Referring to FIG. 30, the first fence structure 438 may be formed on the portion of the isolation pattern 110 between facing end portions of the first ones of the active patterns 105 adjacent to each other in the third direction D3. The first fence structure 438 may include third and fourth fence patterns 413 and 437 sequentially stacked, e.g., the third and fourth fence patterns 413 and 437 may be in direct contact with each other.

A width in the second direction D2 of the third fence pattern 413 may decrease as a distance from the upper surface of the substrate 100 in the vertical direction increases. A width in the second direction D2 of the fourth fence pattern 437 may increase and then may become constant as a distance from the upper surface of the substrate 100 in the vertical direction increases. A width in the second direction D2 of an upper surface of the third fence 413 may be smaller than a width in the second direction D2 of a lower surface of the fourth fence pattern 437. That is, a width in the second direction D2 of the first fence structure 438 may decrease, rapidly increase, and then become constant as a distance from the upper surface of the substrate 100 in the vertical direction increases. For example, as illustrated in FIG. 30, the third fence 413 may be centered with respect to the lower surface of the fourth fence pattern 437, such that the lower surface of the fourth fence pattern 437 may extend in the second direction D2 beyond each of the upper and lower surfaces of the third fence 413. For example, each of the third and fourth fence patterns 413 and 437 may include an oxide, e.g., silicon oxide, or an insulating nitride, e.g., silicon nitride, and may be substantially the same material or different materials from each other.

The lower contact plug 430 may be formed between the first fence pattern 410 and the first fence structure 438, and may contact (e.g., directly contact) the first fence pattern 410 and the first fence structure 438. Accordingly, a lower portion of a first sidewall of the lower contact plug 430 contacting the first fence pattern 410 may be inclined with respect to the upper surface of the substrate 100, and an upper portion of the first sidewall may be vertical with respect to the upper surface of the substrate 100. A second sidewall of the lower contact plug 430 (i.e., a sidewall opposite the first sidewall) contacting the first fence structure 438 may have a shape of a staircase (e.g. a stepped structure). For example, as illustrated in FIG. 30, the second sidewall of the lower contact plug 430 may continuously trace the shapes of the sidewall and lower surface of the fourth fence pattern 437 and the sidewall of the third fence pattern 413, e.g., to extend in the vertical and horizontal directions to have an approximate vertical cross-section of a staircase or of an L-shape.

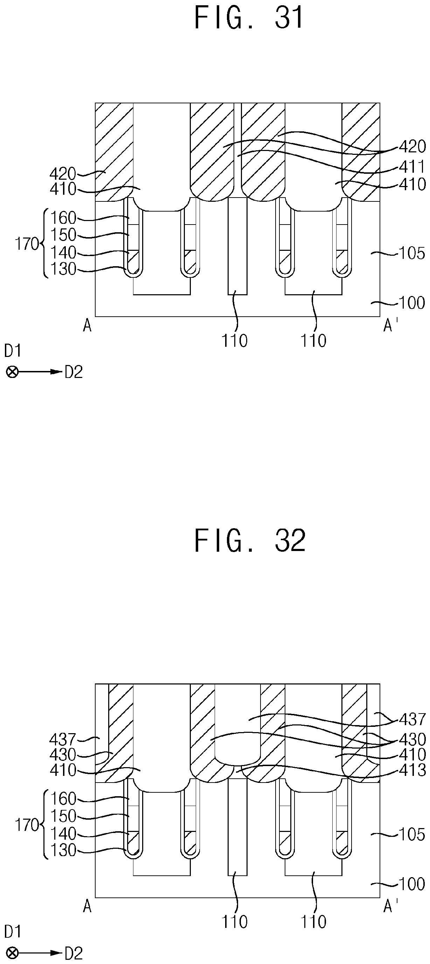

FIGS. 31 and 32 are cross-sectional views taken along lines A-A' of corresponding plan views, respectively, illustrating stages in a method of manufacturing a semiconductor device in accordance with example embodiments. This method may include processes substantially the same as or similar to those illustrated with reference to FIGS. 4 to 29 and FIGS. 1 to 3, and repeated explanations thereof are omitted herein.

Processes substantially the same as or similar to those described with reference to FIGS. 3 to 19 may be performed.

Referring to FIG. 31, unlike the processes illustrated with reference to FIGS. 17 to 19, a fourth mask including a plurality of ninth openings, each of which may extend in the first direction D1, spaced apart from each other in the second direction D2 may be formed on the bit line structure 355, the preliminary spacer structure 390, and the first fence layer 405, and the first fence layer 405 may be etched by a third etching process using the fourth mask as an etching mask to form a tenth opening.

In example embodiments, the tenth opening may expose the upper surface of an end portion of the active pattern 105, and may also expose the isolation pattern 110 and the gate structure 170 adjacent thereto.

Accordingly, the first fence layer 405 extending in the second direction D2 between the bit line structures 355 may be separated into the first fence pattern 410 and a third preliminary fence pattern 411, which may be spaced apart from each other in the second direction D2. In example embodiments, the first fence pattern 410 may be formed on the portion of the isolation pattern 110 between the end portions of the second ones of the active patterns 105 adjacent to each other in the first direction D1, which may face each other in the second direction D2, and the portion of the gate structure 170 adjacent thereto, and the third preliminary fence pattern 411 may be formed on the portion the isolation pattern 110 between the end portions facing each other of the first ones of the active patterns 105 adjacent to each other in the third direction D3.

In example embodiments, the first fence pattern 410 and the third preliminary fence pattern 411 may be alternately and repeatedly disposed in the second direction D2 between the bit line structures 355.

After removing the fourth mask, the preliminary lower contact plug 420 filling the tenth opening may be formed. A distance between the preliminary lower contact plugs 420 disposed in the second direction D2 may not be constant.

Referring to FIG. 32, a fifth mask including a plurality of eleventh openings, each of which may extend in a first direction D1, spaced apart from each other in the second direction D2 may be formed on the bit line structure 355, the preliminary spacer structure 390, the first fence pattern 410, the third preliminary fence pattern 411 and the preliminary lower contact plug 420, and the third preliminary fence pattern 411 and the preliminary lower contact plug 420 may be etched by performing a fourth etching process using the fifth mask as an etch mask to form a third recess.

In example embodiments, each of the eleventh openings may overlap an upper surface of the third preliminary fence pattern 411 and a portion of an upper surface of a preliminary lower contact plug 420 adjacent thereto.

By the fourth etching process, an upper portion of the third preliminary fence pattern 411 may be etched and the third preliminary fence pattern 411 may transformed into a third fence pattern 413, and each of the preliminary lower contact plugs 420 may be transformed into a plurality of lower contact plugs 430.

In example embodiments, a distance between the lower surfaces of the lower contact plugs 430 disposed in the second direction D2 may not be constant, however, by forming the third recess, a distance between the upper surfaces of the lower contact plugs 430 disposed in the direction D2 may be substantially constant.

After removing the sixth mask, the fourth fence pattern 437 filling the third recess may be formed. The fourth fence pattern 437 may be formed on the third fence pattern 413, and the third and fourth fence patterns 413 and 437 may collectively form a first fence structure 438.

Processes substantially the same as or similar to those described with reference to FIGS. 23 to 29 and 1 to 3 may be performed to complete the fabrication of the semiconductor device.

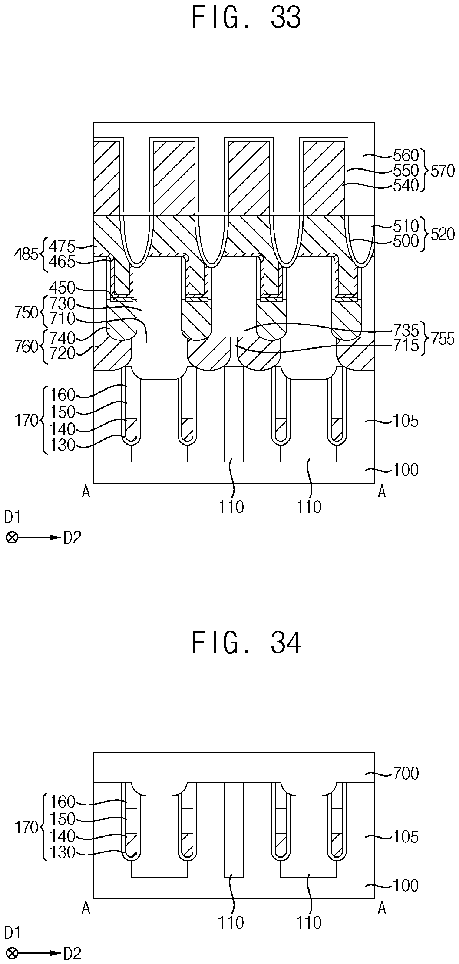

FIG. 33 is a cross-sectional view illustrating a semiconductor device in accordance with example embodiments, which corresponds to FIG. 2. The semiconductor device may be substantially the same as or similar to that of FIGS. 1 to 3, except for including second and third fence structures 750 and 755 instead of the first and third fence patterns 410 and 435, and including the lower contact plug structure 760 instead of the lower contact plug 430, and thus repeated explanations are omitted herein.

Referring to FIG. 33, the second fence structure 750 may be formed on the isolation pattern 110 between central portions facing each other of the third ones of the active patterns 105 adjacent to each other in the first direction D 1. The second fence structure 750 may include fifth and seventh fence patterns 710 and 730 sequentially stacked in the vertical direction.

In example embodiments, the fifth fence pattern 710 may include first and second portions sequentially stacked in the vertical direction on the isolation pattern 110 between the central portions facing each other of the third ones of the active patterns 105 adjacent to each other in the first direction D1.

The first portion of the fifth fence pattern 710 may be formed on the portion of the isolation pattern 110, and a width in the second direction D2 thereof may increase as a distance from the substrate 100 in the vertical direction increases. The second portion of the fifth fence pattern 710 may be formed on the first portion, and a width in the second direction D2 may decrease as a distance from the substrate 100 in the vertical direction increases. A width in the second direction D2 of an upper surface of the first portion of the fifth fence pattern 710 may be smaller than a width in the second direction D2 of a lower surface of the second portion of the fifth fence pattern 710. A width in the second direction D2 of the seventh fence pattern 730 may decrease, and then may be substantially constant as a distance from the upper surface of the substrate 100 in the vertical direction increases.

In example embodiments, a maximum width in the second direction D2 of the fifth fence pattern 710 may be greater than a maximum width in the second direction D2 of the seventh fence pattern 730.

In example embodiments, a width in the second direction D2 of the seventh fence structure 730 may increase, rapidly increase, decrease and then be substantially constant as a distance from the upper surface of the substrate 100 in the vertical direction increases.

The third fence structure 755 may be formed on a portion of the isolation pattern 110 between the end portions facing each other of the first ones of the active patterns 105 adjacent to each other in the third direction D3. The third fence structure 755 may include sixth and eighth fence patterns 715 and 735 sequentially stacked in the vertical direction.

A width in the second direction D2 of the sixth fence pattern 715 may decrease as a distance from the upper surface of the substrate 100 in the vertical direction increases. A width in the second direction D2 of the fourth fence pattern 437 may decrease and then be substantially constant as a distance from the upper surface of the substrate 100 in the vertical direction increases. A width in the second direction D2 of the upper surface of the sixth fence pattern 715 may be smaller than a width in the second direction D2 of the lower surface of the eighth fence pattern 735.

In example embodiments, a maximum width in the second direction D2 of the sixth fence pattern 715 may be smaller than a maximum width in the second direction D2 of the eighth fence pattern 735.

In example embodiments, a width in the second direction D2 of the first fence structure 438 may decrease, suddenly increase, decrease, and then be substantially constant as a distance from the upper surface of the substrate 100 in the vertical direction increases.

The lower contact plug structure 760 may be formed on each of the end portions of the active patterns 105, and may include fourth and fifth conductive patterns 720 and 740 sequentially stacked in the vertical direction. Each of the fourth and fifth conductive patterns 720 and 740 may include, e.g., polysilicon doped with n-type impurities or p-type impurities, and may include substantially the same material or different materials from each other.

The lower contact plug structures 760 may be formed between and contact the second fence structure 750 and the third fence structure 755. Specifically, the fourth conductive pattern 720 may be formed between the fifth and sixth fence patterns 710 and 715, and the fifth conductive pattern 740 may be formed between the seventh and eighth fence patterns 730 and 735.

The fifth conductive pattern 740 may contact the fourth conductive pattern 720, however, may be formed to be offset from the fourth conductive pattern 720 in the second direction D2, e.g., sidewalls of the fourth and fifth conductive patterns 720 and 740 may be misaligned. Accordingly, sidewalls of the lower contact plug structure 760 contacting the seventh fence structure 730 may have a shape of a staircase (e.g. a stepped shape), e.g., due to a shape defined by the misaligned sidewalls.

A distance between the fourth conductive patterns 720 respectively formed on the end portions of the third ones of the active patterns 105 disposed in the second direction D2 may not be constant. However, a distance between the fifth conductive patterns 740, which may contact the fourth conductive patterns 720 and be offset from the fourth conductive patterns 720 in the second direction D2, may be substantially constant. Accordingly, the difficulty of forming the upper contact plugs 485 on the fifth conductive patterns 740, respectively, of the lower contact plug structure 760 may be reduced.

FIGS. 34 to 36 are cross-sectional views taken along lines A-A' of corresponding plan views, respectively, illustrating a method of manufacturing a semiconductor device in accordance with example embodiments.

This method may include processes substantially the same as or similar to those illustrated with reference to FIGS. 4 to 29 and FIGS. 1 to 3, and repeated explanations thereof are omitted herein.

Processes substantially the same as or similar to those described with reference to FIGS. 3 to 14 may be performed.

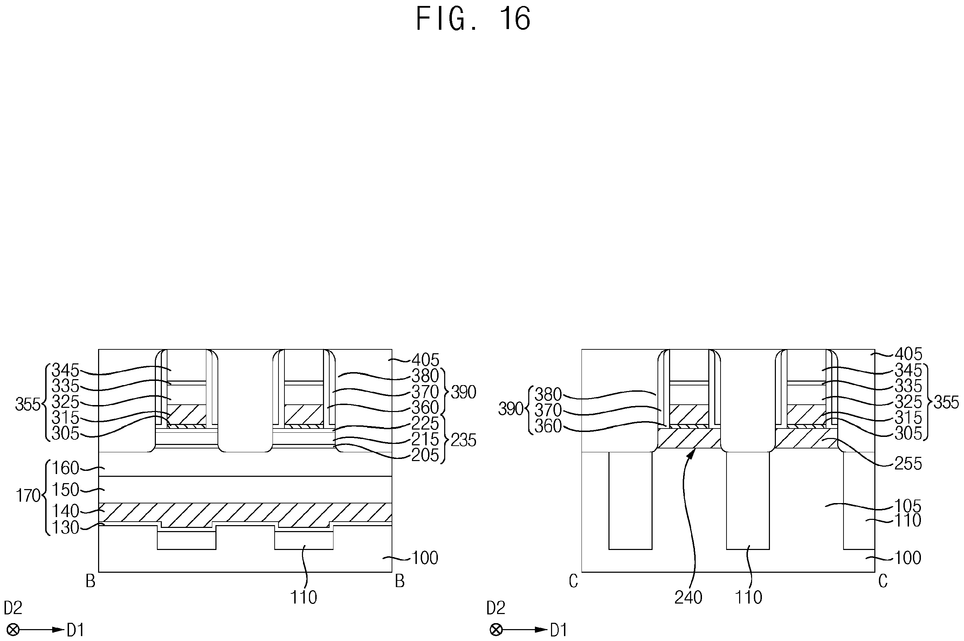

Referring to FIG. 34, unlike the processes illustrated with reference to FIGS. 15 and 16, a fifth fence layer 700 may be formed on the bit line structure 355, the preliminary spacer structure 390, the active pattern 105 and the isolation pattern 110 to a sufficient height, and an upper portion thereof may be etched. Accordingly, an upper surface of the fifth fence layer 700 may be lower than the upper surface of the bit line structure 355.

In example embodiments, the fifth fence layer 700 may extend in the second direction D2, and a plurality of fifth fence layers 700 may be spaced apart from each other in the first direction D1 by the bit line structures 355.

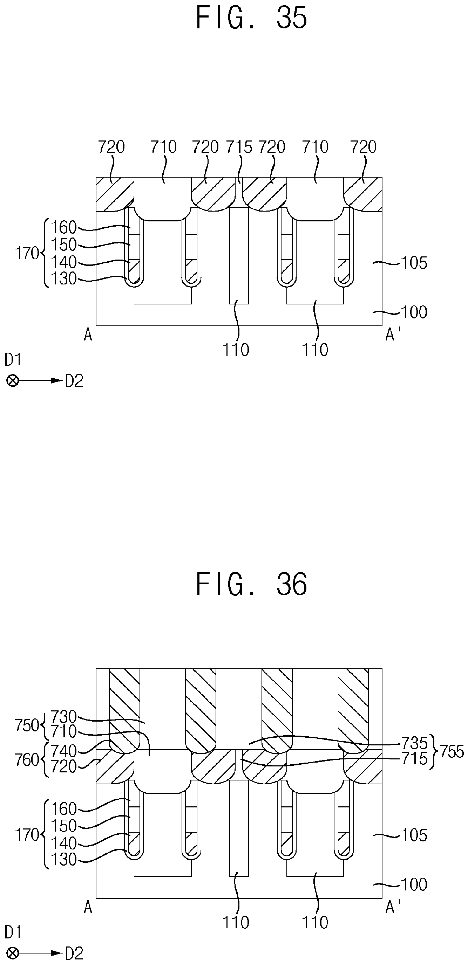

Referring to FIG. 35, a sixth mask including a plurality of twelfth openings, each of which may extend in the first direction D1, spaced apart from each other in the second direction D2 may be formed on the bit line structure 355, the preliminary spacer structure 390 and the fifth fence layer 700, and the fifth fence layer 700 may be etched to form a thirteenth opening by a fifth etching process using the sixth mask as an etching mask.

In example embodiments, the thirteenth opening may expose an upper surface of the end portion of the active pattern 105, and portions of the isolation pattern 110 and the gate structure 170 adjacent thereto may also be exposed.

Accordingly, the fifth fence layer 700 extending in the second direction D2 between the bit line structures 355 may be separated into a fifth fence pattern 710 and a sixth fence pattern 715 spaced apart from each other in the second direction D2 by the thirteenth opening. In example embodiments, the fifth fence pattern 710 may be formed on the portion of the isolation pattern 110 between the end portions of the second ones of the active patterns 105 adjacent to each other in the first direction D1, which may face each other in the second direction D2, and the portion of the gate structure 170 adjacent thereto. The sixth fence pattern 715 may be formed on the portion of the isolation pattern 110 between end portions facing each other of the first ones of the active patterns 105 adjacent to each other in the third direction D3.

In example embodiments, the fifth and sixth fence patterns 710 and 715 may be alternately and repeatedly formed between the bit line structures 355 along the second direction D2.

After removing the fourth mask, a preliminary lower contact plug 420 may be formed to fill the tenth opening. A distance between the preliminary lower contact plugs 420 disposed in the second direction D2 may not be constant.

After removing the sixth mask, a fourth conductive pattern 720 may be formed to fill the thirteenth opening. In this case, a distance between the fourth conductive patterns 720 disposed in the second direction D2 may not be constant.

Referring to FIG. 36, after forming a seventh fence layer on the fifth and sixth fence patterns 710 and 715 and the fourth conductive pattern 720 to a sufficient height, an upper portion thereof may be planarized.

In example embodiments, the seventh fence layer may extend in the second direction D2, and a plurality of seventh fence layers may be spaced apart from each other in by the bit line structures 355 along the first direction D1.

A seventh mask including a plurality of fourteenth openings, each of which may extend in the first direction D1, spaced apart from each other in the second direction D2 may be formed on the bit line structure 355, the preliminary spacer structure 390 and the seventh fence layer, and the seventh fence layer may be etched to from a fifteenth opening by performing a sixth etching process using the seventh mask an etching mask.

In example embodiments, the fifteenth opening may partially expose an upper surface of the fourth conductive pattern 720, and a plurality of fifteenth openings may be spaced apart from each other along the first and second directions D1 and D2. A distance between the fifteenth openings disposed in the second direction D2 may be substantially constant.

The seventh fence layer extending in the second direction D2 between bit line structures 355 adjacent to each other in the first direction D1 may be transformed into seventh and eighth fence patterns 730 and 735 alternately and repeatedly disposed along the second direction D2. The seventh and eighth fence patterns 730 and 735 may be formed on the fifth and sixth fence patterns 710 and 715, respectively. The fifth and seventh fence patterns 710 and 730 collectively form a second fence structure 750, and the sixth and eighth fence patterns 715 and 735 may collectively form the third fence structure 755.

After removing the seventh mask, a fifth conductive pattern 740 may be formed to fill the fifteenth opening. A distance between the fifteenth openings may be substantially constant, and thus a distance between the fifth conductive patterns 740 formed in the fifteenth openings may also be substantially constant. The fourth and fifth conductive patterns 720 and 740 may collectively form a lower contact plug structure 760.

Processes substantially the same as or similar to those described with reference to FIGS. 23 to 29 and 1 to 3 may be performed to complete the fabrication of the semiconductor device.

By way of summation and review, example embodiments provide a semiconductor device having improved electrical characteristics. That is, in the semiconductor device in accordance with example embodiments, even though the distance in the extension direction of the bit line between lower surfaces of the lower contact plugs is not constant, the distance in the extension direction of the bit line between upper surfaces of the lower contact plugs respectively disposed on end portions of the active patterns may be substantially constant. Accordingly, the difficulty of forming upper contact plugs respectively on the lower contact plugs may be reduced.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

Further embodiments are set out in the following clauses:
1. A semiconductor device, comprising:
   a substrate;
   active patterns on the substrate;
   an isolation pattern on the substrate, the isolation pattern covering sidewalls of the active patterns;
   gate structures extending in a first direction through upper portions of the active patterns and the isolation pattern, the first direction being substantially parallel to an upper surface of the substrate, and the gate structures being spaced apart from each other in a second direction substantially parallel to the upper surface of the substrate and substantially perpendicular to the first direction;
   bit line structures on central portions of the active patterns and the isolation pattern, each of the bit line structures extending in the second direction, and the bit line structures being spaced apart from each other in the first direction;
   lower contact plugs respectively on end portions of the active patterns; and
   upper contact plugs respectively on the lower contact plugs,
   wherein the active patterns are arranged in active pattern rows spaced apart from each other in the second direction, and each of the active pattern rows includes some of the active patterns spaced apart from each other in the first direction and aligned with each other in the first direction,
   wherein each of the active patterns extends in a third direction at an acute angle with respect to each of the first direction and the second direction, and
   wherein a distance between lower surfaces of adjacent ones of the lower contact plugs in the second direction is not constant, and a distance between upper surfaces of the adjacent ones of the lower contact plugs in the second direction is substantially constant.
2. The semiconductor device of clause 1, wherein opposite sidewalls in the second direction of each of the lower contact plugs have a positive slope or a negative slope with respect to the upper surface of the substrate.
3. The semiconductor device of clause 1, wherein opposite sidewalls of a first one of two of the lower contact plugs adjacent to each other in the second direction have a positive slope with respect to the upper surface of the substrate, and opposite sidewalls of a second one of the two of the lower contact plugs have a negative slope with respect to the upper surface of the substrate.
4. The semiconductor device of any preceding clause, wherein:
   a first fence pattern and a second fence pattern are alternately and repeatedly arranged between the lower contact plugs in the second direction, and
   the first fence pattern is on a first portion of the isolation pattern between central portions of ones of the active patterns adjacent to each other in the first direction, and the second fence pattern is on a second portion of the isolation pattern between end portions of ones of the active patterns adjacent to each other in the third direction.
5. The semiconductor device of clause 4, wherein:
   the first fence pattern includes a first portion, a second portion, and a third portion sequentially stacked in a vertical direction substantially perpendicular to the upper surface of the substrate,
   a width in the second direction of the first portion increases as a distance from the upper surface of the substrate in the vertical direction increases, a width in the second direction of the second portion increases as a distance from the upper surface of the substrate in the vertical direction increases, and a width in the second direction of the third portion is substantially constant in the vertical direction, and
   a width in the second direction of the second fence pattern increases and then is substantially constant as a distance from the upper surface of the substrate in the vertical direction increases.
6. The semiconductor device of clause 4 or clause 5, wherein each of the first fence pattern and the second fence pattern includes oxide or nitride.
7. The semiconductor device of clause 6, wherein the first fence pattern and the second fence pattern include different materials from each other.
8. The semiconductor device of any preceding clause, wherein each of the lower contact plugs includes polysilicon doped with n-type impurities or p-type impurities.
9. A semiconductor device, comprising:
   a substrate;
   active patterns on the substrate;
   gate structures extending in a first direction through upper portions of the active patterns, the first direction being substantially parallel to an upper surface of the substrate;
   bit line structures on central portions of the active pattern, the bit line structures extending in a second direction substantially parallel to the upper surface of the substrate and substantially perpendicular to the first direction;
   lower contact plugs respectively on end portions of the active patterns, a distance in the second direction between upper surfaces of the lower contact plugs in the second direction being substantially constant, and a sidewall in the second direction of each of the lower contact plugs having a shape of a staircase; and
   upper contact plugs respectively on the lower contact plugs.
10. The semiconductor device of clause 9, wherein:
   each of the active patterns extends in a third direction at an acute angle with respect to the first direction and the second direction, the active patterns being spaced apart from each other in the first direction, and
   end portions in the third direction of the active patterns are aligned in the first direction with each other.
11. The semiconductor device of clause 10, wherein:
   a first fence pattern and a first fence structure are alternately and repeatedly arranged between the lower contact plugs adjacent to each other in the second direction,
   the first fence pattern is between central portions of the active patterns adjacent to each other in the first direction, and the first fence structure is between end portions of the active patterns adjacent to each other in the third direction, in a top view, and
   the sidewall of the lower contact plug having the shape of the staircase is in contact with the first fence structure.
12. The semiconductor device of clause 11, wherein:
   the first fence pattern includes a first portion, a second portion, and a third portion sequentially stacked in a vertical direction substantially perpendicular to the upper surface of the substrate, and
   a width in the second direction of the first portion increases as a distance from the upper surface of the substrate in the vertical direction increases, a width in the second direction of the second portion decreases as the distance from the upper surface of the substrate in the vertical direction increases, and a width in the second direction of the third portion is substantially constant in the vertical direction.
13. The semiconductor device of clause 11 or clause 12, wherein:
   the first fence structure includes a second fence pattern and a third fence pattern sequentially stacked in a vertical direction substantially perpendicular to the upper surface of the substrate,
   a width in the second direction of the second fence pattern decreases as a distance from the upper surface of the substrate in the vertical direction increases, and a width in the second direction of the third fence pattern decreases as a distance from the upper surface of the substrate in the vertical direction increases, and
   a width in the second direction of an upper surface of the second fence pattern is smaller than a width in the second direction of a lower surface of the third fence pattern.
14. The semiconductor device of any of clauses 11-13, wherein the first fence pattern and the first fence structure include oxide or nitride.
15. The semiconductor device of clause 14, wherein:
   the first fence structure includes a second fence pattern and a third fence pattern sequentially stacked in a vertical direction, and
   the first and second fence patterns include the same material, and the third fence pattern includes a material different from the material of the first and second fence patterns.
16. A semiconductor device, comprising:
   a substrate;
   active patterns on the substrate;
   gate structures extending in a first direction through upper portions of the active patterns, the first direction being substantially parallel to an upper surface of the substrate;
   bit line structures on central portions of the active pattern, the bit line structures extending in a second direction substantially parallel to the upper surface of the substrate and substantially perpendicular to the first direction;
   lower contact plugs respectively on end portions of the active patterns, each of the lower contact plugs including a first conductive pattern and a second conductive pattern sequentially stacked in a vertical direction substantially perpendicular to the upper surface of the substrate, a distance in the second direction between the first conductive patterns is not constant, and a distance in the second direction between the second conductive patterns being substantially constant; and
   upper contact plugs respectively on the lower contact plugs.
17. The semiconductor device of clause 16, wherein the second conductive pattern is in contact with the first conductive pattern, and is offset from the first conductive pattern in the second direction.
18. The semiconductor device of clause 17, wherein:
   each of the active patterns extends in a third direction at an acute angle with respect to the first direction and the second direction, the active patterns being spaced apart from each other in the first direction, and
   end portions in the third direction of the active patterns are aligned in the first direction with each other.
19. The semiconductor device of any of clauses 16-18, wherein:
   a first fence structure and a second fence structure are alternately and repeatedly arranged between the lower contact plugs adjacent to each other in the second direction,
   the first fence structure is between central portions of the active patterns adjacent to each other in the first direction, and the second fence structure is between end portions of the active patterns adjacent to each other in a third direction in a top view, and
   the first fence structure includes a first fence pattern and a second fence pattern stacked in the vertical direction, and the second fence structure includes a third fence pattern and a fourth fence pattern stacked in the vertical direction.
20. The semiconductor device of clause 19, wherein:
   a maximum width in the second direction of the first fence pattern is greater than a maximum width in the second direction of the second fence pattern, and
   a maximum width in the second direction of the third fence pattern is smaller than a maximum width in the second direction of the fourth fence pattern.

## Claims

1. A semiconductor device, comprising:
a substrate;
active patterns on the substrate;
an isolation pattern on the substrate, the isolation pattern covering sidewalls of the active patterns;
gate structures extending in a first direction through upper portions of the active patterns and the isolation pattern, the first direction being substantially parallel to an upper surface of the substrate, and the gate structures being spaced apart from each other in a second direction substantially parallel to the upper surface of the substrate and substantially perpendicular to the first direction;
bit line structures on central portions of the active patterns and the isolation pattern, each of the bit line structures extending in the second direction, and the bit line structures being spaced apart from each other in the first direction;
lower contact plugs respectively on end portions of the active patterns; and
upper contact plugs respectively on the lower contact plugs,
wherein the active patterns are arranged in active pattern rows spaced apart from each other in the second direction, and each of the active pattern rows includes some of the active patterns spaced apart from each other in the first direction and aligned with each other in the first direction,
wherein each of the active patterns extends in a third direction at an acute angle with respect to each of the first direction and the second direction, and
wherein a distance between lower surfaces of adjacent ones of the lower contact plugs in the second direction is not constant, and a distance between upper surfaces of the adjacent ones of the lower contact plugs in the second direction is substantially constant.

2. The semiconductor device as claimed in claim 1, wherein opposite sidewalls in the second direction of each of the lower contact plugs have a positive slope or a negative slope with respect to the upper surface of the substrate.

3. The semiconductor device as claimed in claim 1, wherein opposite sidewalls of a first one of two of the lower contact plugs adjacent to each other in the second direction have a positive slope with respect to the upper surface of the substrate, and opposite sidewalls of a second one of the two of the lower contact plugs have a negative slope with respect to the upper surface of the substrate.

4. The semiconductor device as claimed in any preceding claim, wherein:
a first fence pattern and a second fence pattern are alternately and repeatedly arranged between the lower contact plugs in the second direction, and
the first fence pattern is on a first portion of the isolation pattern between central portions of ones of the active patterns adjacent to each other in the first direction, and the second fence pattern is on a second portion of the isolation pattern between end portions of ones of the active patterns adjacent to each other in the third direction.

5. The semiconductor device as claimed in claim 4, wherein:
the first fence pattern includes a first portion, a second portion, and a third portion sequentially stacked in a vertical direction substantially perpendicular to the upper surface of the substrate,
a width in the second direction of the first portion increases as a distance from the upper surface of the substrate in the vertical direction increases, a width in the second direction of the second portion decreases as a distance from the upper surface of the substrate in the vertical direction increases, and a width in the second direction of the third portion is substantially constant in the vertical direction, and
a width in the second direction of the second fence pattern increases and then is substantially constant as a distance from the upper surface of the substrate in the vertical direction increases.

6. The semiconductor device as claimed in claim 4 or claim 5, wherein each of the first fence pattern and the second fence pattern includes oxide or nitride.

7. The semiconductor device as claimed in claim 6, wherein the first fence pattern and the second fence pattern include different materials from each other.

8. The semiconductor device as claimed in any preceding claim, wherein each of the lower contact plugs includes polysilicon doped with n-type impurities or p-type impurities.

9. A semiconductor device, comprising:
a substrate;
active patterns on the substrate;
gate structures extending in a first direction through upper portions of the active patterns, the first direction being substantially parallel to an upper surface of the substrate;
bit line structures on central portions of the active pattern, the bit line structures extending in a second direction substantially parallel to the upper surface of the substrate and substantially perpendicular to the first direction;
lower contact plugs respectively on end portions of the active patterns, a distance in the second direction between upper surfaces of the lower contact plugs in the second direction being substantially constant, and a sidewall in the second direction of each of the lower contact plugs having a shape of a staircase; and
upper contact plugs respectively on the lower contact plugs.

10. The semiconductor device as claimed in claim 9, wherein:
each of the active patterns extends in a third direction at an acute angle with respect to the first direction and the second direction, the active patterns being spaced apart from each other in the first direction, and
end portions in the third direction of the active patterns are aligned in the first direction with each other.

11. The semiconductor device as claimed in claim 10, wherein:
a first fence pattern and a first fence structure are alternately and repeatedly arranged between the lower contact plugs adjacent to each other in the second direction,
the first fence pattern is between central portions of the active patterns adjacent to each other in the first direction, and the first fence structure is between end portions of the active patterns adjacent to each other in the third direction, in a top view, and
the sidewall of the lower contact plug has the shape of the staircase is in contact with the first fence structure.

12. The semiconductor device as claimed in claim 11, wherein:
the first fence pattern includes a first portion, a second portion, and a third portion sequentially stacked in a vertical direction substantially perpendicular to the upper surface of the substrate, and
a width in the second direction of the first portion increases as a distance from the upper surface of the substrate in the vertical direction increases, a width in the second direction of the second portion decreases as the distance from the upper surface of the substrate in the vertical direction increases, and a width in the second direction of the third portion is substantially constant in the vertical direction.

13. The semiconductor device as claimed in claim 11 or claim 12, wherein:
the first fence structure includes a second fence pattern and a third fence pattern sequentially stacked in a vertical direction substantially perpendicular to the upper surface of the substrate,
a width in the second direction of the second fence pattern decreases as a distance from the upper surface of the substrate in the vertical direction increases, and a width in the second direction of the third fence pattern increases and then is substantially constant as a distance from the upper surface of the substrate in the vertical direction increases, and
a width in the second direction of an upper surface of the second fence pattern is smaller than a width in the second direction of a lower surface of the third fence pattern.

14. The semiconductor device as claimed in any of claims 11-13, wherein the first fence pattern and the first fence structure include oxide or nitride.

15. The semiconductor device as claimed in claim 14, wherein:
the first fence structure includes a second fence pattern and a third fence pattern sequentially stacked in a vertical direction, and
the first and second fence patterns include the same material, and the third fence pattern includes a material different from the material of the first and second fence patterns.
